# EUROPEAN PATENT APPLICATION

(11) **EP 4 697 874 A1**
(43) Date of publication of application: **18.02.2026**
(21) Application number: 23932806.5
(22) Date of filing: 28.11.2023
(51) Int. Cl.: H05K 7/20

(54) **ELECTRONIC DEVICE**

(30) Priority: 14.04.2023 CN 202310409714
(71) Applicant: xFusion Digital Technologies Co., Ltd., Zhengzhou, Henan 450000 (CN)
(72) Inventor: HUANG, Qiuyue, Zhengzhou, Henan 450000 (CN); FENG, Xue, Zhengzhou, Henan 450000 (CN); XIANG, Lei, Zhengzhou, Henan 450000 (CN)
(74) Representative: Isarpatent
(86) International application number: PCT/CN2023/134680
(87) International publication number: WO 2024/212535

(57) **Abstract**

The present application provides an electronic device, including a chassis body, and a first partition plate, a middle layer plate, a board, and a first cushioning member that are disposed in the chassis body, where an accommodation space of the chassis body includes a first air channel and a second air channel, and the second air channel and the first air channel are sequentially disposed along a height direction of the electronic device; the board is fixedly connected to the chassis, the board extends along the height direction of the electronic device, and the board includes a first surface and a second surface that are disposed facing away from each other; the first partition plate is connected to the chassis body, and the first partition plate is further connected to the first surface; the first cushioning member is connected to the second surface; the middle layer plate is connected to the chassis body, and the middle layer plate is further connected to the first cushioning member; and the first air channel and the second air channel are isolated by the first partition plate, the board, the first cushioning member, and the middle layer plate. The technical solution of the present application ensures good heat dissipation performance of the electronic device.

## Description

This application claims priority to the Chinese Patent Application filed with the China National Intellectual Property Administration on April 14, 2023, with application number 202310409714.7, and titled "ELECTRONIC DEVICE", the entire content of which is incorporated by reference into this application.

### TECHNICAL FIELD

This application relates to the field of electronic technologies, and particularly to an electronic device.

### BACKGROUND

With the rise of big data, cloud computing, and AI (Artificial intelligence, artificial intelligence), the application demands for electronic devices such as servers and supercomputers are becoming increasingly widespread. To enhance competitiveness, computing speeds and storage capacities of the electronic devices need to be enhanced by increasing configuration density. The enhanced computing speeds and storage capacities easily lead to increasingly high power consumption of the electronic devices. Currently, high configuration densities in the electronic devices easily cause uneven heat dissipation in the devices, thereby resulting in overheating in local areas of the devices. Therefore, heat dissipation of the devices gradually becomes a bottleneck.

### SUMMARY

Embodiments of the present application provide an electronic device having good heat dissipation performance.

The electronic device provided in the embodiments of the present application includes a chassis body, a first partition plate, a middle layer plate, a board, and a first cushioning member, where the chassis body is provided with an accommodation space, and the first partition plate, the middle layer plate, the board, the first fan module, the second fan module, and the first cushioning member are all located in the accommodation space;
the board is fixedly connected to the chassis body, the board extends along a height direction of the electronic device, and the board includes a first surface and a second surface that are disposed facing away from each other;
the first partition plate is fixedly connected to the chassis body, the first partition plate is further connected to the first surface of the board, and the first partition plate extends along a length direction of the electronic device;
the first cushioning member is connected to the second surface of the board, and the first cushioning member extends along a width direction of the electronic device;
the middle layer plate is fixedly connected to the chassis body, the middle layer plate is further connected to the first cushioning member, and the middle layer plate extends along the length direction of the electronic device; and
the accommodation space includes a first air channel and a second air channel, the second air channel and the first air channel are sequentially disposed in a height direction of the electronic device, and the first air channel and the second air channel are isolated by the first partition plate, the board, the first cushioning member, and the middle layer plate.

It may be understood that, if there is a relatively large gap between the first air channel and the second air channel, the second air channel and the first air channel are in communication with each other, so that the first air channel and the second air channel are connected and coupled to each other, thereby causing air volume bypass or air leakage, resulting in poor heat dissipation in the second air channel.

The first air channel and the second air channel are arranged independently of each other, and the first air channel and the second air channel may be isolated from each other, so that air flow in the first air channel and air flow in the second air channel may not produce adverse effects caused by mutual mixing, thereby significantly reducing occurrence of problems such as airflow bypass or leakage into a low-resistance zone caused by unmatched resistance. In addition, cold air in the first air channel only dissipates heat from a module located in the first air channel, and cold air in the second air channel only dissipates heat from a module located in the second air channel. Therefore, air volume matching and heat dissipation capability upgrade may be performed according to heat dissipation requirements of modules in respective air channels, which helps improve overall heat dissipation performance of the electronic device.

In a possible implementation, the middle layer plate includes a base plate and a connecting member, the base plate includes a first side edge facing the board, and the first side edge is spaced apart from the first cushioning member, and in the width direction of the electronic device, a length of the connecting member is greater than or equal to a length of the first side edge, the connecting member includes a first connecting member and a second connecting member, the first connecting member is fixedly connected to the first side edge, the second connecting member protrudes from the first side edge, and the second connecting member is connected to the first cushioning member.

It may be understood that, because there is a gap between the first cushioning member and the first side edge of the base plate, air above the middle layer plate is easily caused to flow from the gap between the first cushioning member and the first side edge of the base plate to below the middle layer plate (that is, from the first air channel to the second air channel), or air below the middle layer plate flows from the gap between the first cushioning member and the first side edge of the base plate to above the middle layer plate (from the second air channel to the first air channel), so that air in the air channels of the electronic device is mixed with each other. In this way, heat dissipation balance of the electronic device is broken due to uneven air volume matching between the first air channel and the second air channel, and high temperature is prone to occur at a local position in the electronic device. By disposing the connecting member and extending the connecting member all the way to the first cushioning member, on one hand, the first cushioning member may absorb the gap and deformation deviation between the middle layer plate and the board. This ensures good air tightness performance between the middle layer plate and the board, preventing air on one side of the middle layer plate from leaking to the other side of the middle layer plate, thereby maintaining uniform temperature in the electronic device, and enhancing heat dissipation performance of the electronic device. On the other hand, by extending the connecting member of the middle layer plate to the first cushioning member, during assembly, transportation, and maintenance of the electronic device, the first cushioning member, due to its good cushioning property, may provide shock absorption protection for the middle layer plate and the board, thereby avoiding damage caused by direct impact between the middle layer plate and the board, and enhancing reliability.

In a possible implementation, the second connecting part includes a first section, a bent section, and a second section, the second section and the first section are stacked, the bent section is bent and connected between the first section and the second section, and the bent section is in contact with the first cushioning member, and a thickness of the second connection part is greater than a thickness of the first connection part.

In this configuration, the bent section and the second section may together form an upward or downward folded edge structure relative to the first section. On one hand, the folded edge structure may increase a contact area with the first cushioning member, and ensure good contact stability and reliability between the middle layer plate and the first cushioning member. On the other hand, the folded edge structure may increase strength of the second connecting part, so that the second connecting part is not easily damaged. For example, a surface of the bent section in contact with the first cushioning member may be an arc surface.

In a possible implementation, the second surface of the board includes a first area and a second area that are adjacently disposed, the electronic device further includes a first insulator, the first insulator is connected to the second area, and a first mounting slot is recessed in a surface of the first insulator away from the board, and at least a part of the first cushioning member is located in the first mounting slot.

It may be understood that, the board may integrate circuits, and interconnect modules in the electronic device through high-density routing. However, the board generally implements a current path of the board by configuring a plurality of groups of conductive bars on the board. The plurality of groups of conductive bars have a plurality of welding points with the board (for example, a group of conductive bars have at least two welding points with the board). In the electronic device, a frame body connected to the board is generally of a metal frame structure. If the frame body is directly connected to the board, the frame body is easily in communication with the welding points of the plurality of groups of conductive bars, thereby resulting in an electrical fault such as a short circuit. Therefore, by disposing a first insulator and a second insulator that are isolated from an external environment at the welding points of the plurality of groups of conductive bars, the plurality of welding points of the plurality of groups of conductive bars may be protected, and faults such as short circuits may be avoided due to contact between the first rear frame body and the second rear frame body and the welding points, thereby enhancing electrical reliability.

The second surface of the board is uneven. The first insulator is additionally disposed on the second surface of the board, so that the first insulator, due to its uniform surface, provides a flat mounting environment for attaching the first cushioning member. Therefore, the first cushioning member has good flatness when mounted on the first insulator, which is conducive to better exerting operating performance of the first cushioning member.

In a possible implementation, the electronic device further includes a second cushioning member, the second cushioning member is connected to the first surface of the board, and a surface of the second cushioning member facing away from the board is connected to the first partition plate.

On one hand, the second cushioning member disposed between the first partition plate and the board may absorb the gap and deformation deviation between the first partition plate and the board. This ensures good sealing performance between the first partition plate and the board, preventing air flowing in a first functional zone from leaking to other functional zones. On the other hand, the second cushioning member disposed between the first partition plate and the board, due to its good cushioning property, may also provide shock absorption protection for the first partition plate and the board during assembly, transportation, and maintenance of the electronic device, thereby avoiding damage caused by direct impact between the first partition plate and the board, and enhancing reliability.

In a possible implementation, the first partition plate includes a first partition plate body and a first folded edge, the first folded edge is connected to an end of the first partition plate body facing the board, the first folded edge is arranged at an included angle with the first partition plate body, and the first folded edge is connected to the second cushioning member.

It may be understood that, by disposing the first folded edge and arranging the first folded edge at an included angle with the first partition body, the first folded edge may be bent relative to the first partition plate body, and the bent first folded edge may be connected to the board. Compared to directly connecting the partition plate to the board, the first folded edge is additionally disposed as a part in the first partition plate connected to the board, so that there is a large contact area between the first partition plate and the board, which is beneficial to ensuring stability and reliability of connection between the first partition plate and the board when the first front frame body is connected to the board.

In a possible implementation, the electronic device further includes a first rear frame body, and the first rear frame body is detachably connected to the chassis body;
the first rear frame body includes an upper layer plate, the middle layer plate, a lower layer plate, a first side plate, and a second side plate, where along the height direction of the electronic device, the lower layer plate, the middle layer plate, and the upper layer plate are arranged sequentially and spaced apart from each other; and along the width direction of the electronic device, the first side plate and the second side plate are respectively connected to opposite sides of the lower layer plate, the middle layer plate, and the upper layer plate;
the upper layer plate, the middle layer plate, the board, the first side plate, and the second side plate cooperate to enclose a fan zone, where the fan zone is located in the first air channel, and the fan zone is configured to accommodate a fan module or a functional module; and
the middle layer plate, the board, the lower layer plate, the first side plate, and the second side plate cooperate to enclose a pluggable module zone, where the pluggable module zone is located in the second air channel, and the pluggable module zone is configured to accommodate a fan module or a functional module.

It may be understood that, by properly arranging relative positions of the plates in the first rear frame body, an upper area of the first rear frame body may integrate a fan module or a functional module, and a lower area of the first rear frame body may integrate a functional module or a fan module. Thus, the first rear frame body is divided into two independent functional zones: the fan zone and the pluggable module zone. In other words, the first rear frame body may integrate a plurality of modules with different functions, so that performance of the first rear frame body may be diversified, which is beneficial to multi-scenario application of the first rear frame body.

In a possible implementation, the first rear frame body further includes a clamping plate and a plurality of first baffles, and two ends of the clamping plate are respectively connected to the first side plate and the second side plate, and along the height direction of the electronic device, the clamping plate is located between the upper layer plate and the lower layer plate and is spaced apart from the upper layer plate and the lower layer plate, a plurality of first baffles are spaced apart in a gap area between the upper layer plate and the clamping plate and a gap area between the clamping plate and the middle layer plate, and a gap area between two adjacent first baffles is configured to accommodate a fan.

It may be understood that, the clamping plate is disposed between the upper layer plate and the middle layer plate, so that the fan zone of the first rear frame body may be divided by the clamping plate into an upper layer area and a lower layer area. The upper layer area may be configured to accommodate a plurality of fans, and the lower layer area may also accommodate a plurality of fans. In this way, as many fans as possible may be arranged in a limited space layout, which is conducive to enhancing space utilization of the first rear frame body and heat dissipation performance of the electronic device.

In a possible implementation, the electronic device further includes a first fan board and a second fan board;
the first fan board is fixedly connected to the clamping plate, the first fan board is spaced apart from each of the plurality of first baffles connected between the upper layer plate and the clamping plate, and the first fan board is configured to be electrically connected to a plurality of fans located between the upper layer plate and the clamping plate; and
the second fan board is fixedly connected to the middle layer plate, one end of the second fan board extending from the middle layer plate is connected to the board through the first insulator, and the second fan board is spaced apart from each of the plurality of first baffles connected between the clamping plate and the middle layer plate, the second fan board is configured to be electrically connected to a plurality of fans located between the clamping plate and the middle layer plate, and the second fan board is electrically connected to the first fan board and the board.

It may be understood that the first fan board may independently control the plurality of fans located at an upper layer of the fan zone, the second fan board may independently control the plurality of fans located at a lower layer of the fan zone, and the second fan board is further electrically connected between the fan board and the board. Therefore, by using the board, the fan may perform fine control on the plurality of fans located at the upper layer of the fan zone and/or the plurality of fans located at the lower layer of the fan zone. That is, by independently controlling the fan module, a quantity of fans adapted to corresponding heat dissipation requirements may be configured based on temperature in the chassis body, so that precise speed adjustment and heat dissipation capability of the fan module may be upgraded.

In a possible implementation, the electronic device further includes a second insulator, a third cushioning member, and a first top plate;
the first top plate is fixedly connected to the chassis body, and along the height direction of the electronic device, the first top plate is stacked with the lower layer plate of the first rear frame body; and
the second insulator is connected to the second area, the second insulator and the first insulator are opposite each other and spaced apart, a second mounting slot is recessed in a surface of the second insulator away from the board, a second mounting slot is recessed in a surface of the second insulator away from the board, and at least a part of the third cushioning member is located in the second mounting slot, and a surface of the third cushioning member away from the second insulator is configured to be connected to the first top plate.

In a possible implementation, the first top plate of the electronic device includes a first top plate body and an extension edge, one end of the extension edge is fixedly connected to the first top plate body, and the other end of the extension edge is connected to the third cushioning member, and the extension edge is arranged at an included angle with the first top plate body.

It may be understood that, the second surface of the board is uneven. The second insulator is additionally disposed on the second surface of the board, so that the second insulator, due to its uniform surface, provides a flat mounting environment for attaching the third cushioning member. Therefore, the third cushioning member has good flatness when mounted on the second insulator, which is conducive to better exerting operating performance of the third cushioning member.

In a possible implementation, the accommodation space further includes a third air channel, where the third air channel, the second air channel, and the first air channel are sequentially disposed in the height direction of the electronic device, and the electronic device further includes a second partition plate, and the second partition plate is fixedly connected to the chassis body and spaced apart from the first partition plate, the second partition plate is further connected to the first surface of the board, and the second partition plate extends along the length direction of the electronic device; and the third air channel and the second air channel are isolated by the second partition plate, the board, the third cushioning member, and the first top plate.

It may be understood that, in the third air channel, a small built-in fan is provided in the third functional module to blow air, and a flow direction of the third air channel may be consistent with a flow direction of the second air channel. Since the third air channel has a relatively small air volume and a relatively low air speed, and the second air channel has a relatively large air volume and a relatively large air speed, in order to prevent the air outlet of the second air channel from affecting the air outlet of the third air channel, the second air channel is isolated from the third air channel.

By configuring the third air channel and the second air channel independently of each other, the third air channel and the second air channel may be isolated from each other because they are not in communication with each other, so that air flow in the third air channel and air flow in the second air channel may not produce adverse effects due to mutual mixing, thereby significantly reducing occurrence of problems such as airflow bypass or leakage into a low-resistance zone caused by unmatched resistance. In addition, cold air in the third air channel only dissipates heat from a module located in the third air channel, and cold air in the second air channel only dissipates heat from a module located in the second air channel. Therefore, air volume matching and heat dissipation capability upgrade may be performed according to heat dissipation requirements of modules in respective air channels, which helps improve overall heat dissipation performance of the electronic device.

In a possible implementation, the chassis body, the first partition plate, and the board cooperate to enclose a first functional zone, the first functional zone is located in the first air channel, the first functional zone is in communication with the fan zone, and the first functional zone is configured to accommodate a first functional module;
the chassis body, the first partition plate, the second partition plate, and the board cooperate to enclose a second functional zone, the second functional zone is located in the second air channel, the second functional zone is connected to the pluggable module zone, and the second functional zone is configured to accommodate a second functional module;
the chassis body, the second partition plate, the first top plate, and the board cooperate to enclose a third functional zone, the third functional zone is located in the third air channel, and the third functional zone is configured to accommodate a third functional module; and
along the height direction of the electronic device, the third functional zone, the second functional zone, and the first functional zone are sequentially disposed.

It may be understood that, based on spacing of the first partition plate and second partition plate, accommodation space of the chassis body may be properly arranged, so that the first functional zone is distributed in an upper area of the chassis body, the second functional zone is distributed in a middle area of the chassis body, and the third functional zone is distributed in a lower area of the chassis body. This ensures that functional zones in the chassis body are independent of each other, so that functional modules may be arranged in corresponding zones more quickly and better based on different functions of the functional zones during assembly of the electronic device, resulting in high efficiency and excellent compatibility.

In a possible implementation, the chassis body, the first partition plate, and the board cooperate to enclose a first functional zone, the first functional zone is located in the first air channel, the first functional zone is in communication with the fan zone, and the first functional zone is configured to accommodate a functional module;
the chassis body, the first partition plate, the second partition plate, and the board cooperate to enclose a second functional zone, the second functional zone is located in the second air channel, the second functional zone is connected to the pluggable module zone, and the second functional zone is configured to accommodate a functional module; and
the electronic device further includes a first fan module and a second fan module, where the first fan module is disposed in the first air channel, and the second fan module is disposed in the second air channel;
the first fan module and the second fan module are located on a same side of the board, where the first fan module is located in the first functional zone, and the second fan module is located in the second functional zone; or
the first fan module and the second fan module are located on a same side of the board, where the first fan module is located in the fan zone, and the second fan module is located in the pluggable module zone; or
the first fan module and the second fan module are located on different sides of the board, where the first fan module is located in the fan zone, and the second fan module is located in the second functional zone; or
the first fan module and the second fan module are located on different sides of the board, where the first fan module is located in the first functional zone, and the first fan module is located in the pluggable module zone.

It may be understood that, by disposing the fan module inside the chassis body, pluggable space occupied by the fan module on a panel of the electronic device, may be reduced, so that the part of space may be configured to configure more pluggable modules, so as to increase a quantity of the pluggable modules in the electronic device. For example, the pluggable module may be a hard disk module.

In a possible implementation, the electronic device is a server.

For example, the server may be a heterogeneous server.

### BRIEF DESCRIPTION OF DRAWINGS

FIG. 1 is a structural diagram of an electronic device according to an embodiment of the present application;
FIG. 2 is an exploded diagram of the electronic device shown in FIG. 1;
FIG. 3 is a structural diagram of a chassis body of the electronic device shown in FIG. 1;
FIG. 4 is a partial structural diagram of the electronic device shown in FIG. 1;
FIG. 5 is a structural diagram of a first front frame body shown in FIG. 1 from a perspective;
FIG. 6 is a structural diagram of the first front frame body shown in FIG. 1 from another perspective;
FIG. 7 is a partial structural diagram of the first front frame body shown in FIG. 6;
FIG. 8 is a structural diagram of a second front frame body of the electronic device shown in FIG. 1;
FIG. 9 is a schematic simplified diagram of division of an internal area of the electronic device shown in FIG. 4;
FIG. 10 is another partial structural diagram of the electronic device shown in FIG. 1;
FIG. 11 is a top view of a second surface of a board shown in the figure;
FIG. 12 is a top view of a first surface of the board shown in the figure;
FIG. 13 is an assembly schematic diagram of the board, a first cushioning member and a first insulator shown in FIG. 1;
FIG. 14 is a structural diagram of a first rear frame body of the electronic device shown in FIG. 1;
FIG. 15 is an assembly schematic diagram of a first fan board, a second fan board, and the first rear frame body of the electronic device shown in FIG. 1;
FIG. 16 is a structural diagram of a base plate of a middle layer plate of the first rear frame body shown in FIG. 14;
FIG. 17 is a structural diagram of a connecting member of the middle layer plate of the first rear frame body shown in FIG. 15;
FIG. 18 is a structural diagram of a connection between the connecting member and the first cushioning member shown in FIG. 17;
FIG. 19 is another partial structural diagram of the electronic device shown in FIG. 1;
FIG. 20 is a structural diagram of a second rear frame body of the electronic device shown in FIG. 1;
FIG. 21 is a structural diagram of a first top plate of the first rear frame body shown in the figure;
FIG. 22 is a structural diagram of the first top plate of the first rear frame body connected to a third cushioning member shown in the figure;
FIG. 23 is another schematic simplified diagram of division of an internal area of the electronic device shown in FIG. 1;
FIG. 24 is another schematic simplified diagram of division of an internal area of the electronic device shown in FIG. 1;
FIG. 25 is a schematic diagram of an air channel flow direction when a first air channel and a second air channel are not completely isolated from each other as shown in FIG. 24; and
FIG. 26 is a schematic diagram of an air channel flow direction when the first air channel and the second air channel are completely isolated from each other as shown in FIG. 24.

### DESCRIPTION OF EMBODIMENTS

To facilitate understanding, the terms involved in embodiments of the present application are first explained.

And/or: only refers to an association relationship for describing associated objects and represents that three relationships may exist. For example, A and/or B may represent the following three cases: only A exists, both A and B exist, and only B exists.

A plurality of: represents two or more.

Connected: it should be understood in a broad sense. For example, A is connected to B, which may be a direct connection between A and B, or an indirect connection between A and B via an intermediate medium.

The following provides clear descriptions of implementations of the present application as shown in the accompanying drawings.

Embodiment of the present application provides an electronic device. The electronic device may be, but is not limited to, a server, a router, a switch, a supercomputer, or an AI (Artificial Intelligence, artificial intelligence) device.

To facilitate understanding, the following is described by taking the electronic device being a heterogeneous server in the server for example. However, it should be understood that this is not limited thereto. The heterogeneous server refers to a server that uses different kinds of processors to jointly perform computing tasks, such as CPU (Central Processing Unit, central processing unit), GPU (Graphics Processing Unit, graphics processing unit), FPGA (Field-Programmable Gate Array, field-programmable gate array), TPU (Tensor Processing Unit, tensor processing unit), DPU (Deep Learning Processing Unit, deep learning processing unit), NPU (Neural Network Processing Unit, neural network processing unit), BPU (Brain Processing Unit, brain processing unit), or ASIC (Application Specific Integrated Circuit, application specific integrated circuit).

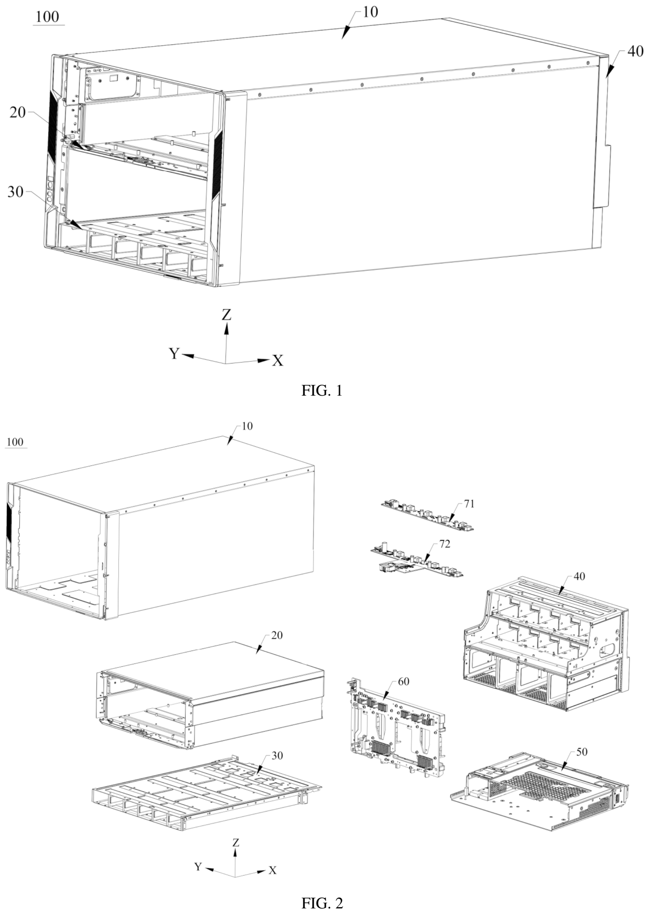

In combination with FIGS. 1 and 2, FIG. 1 is a structural diagram of an electronic device 100 according to an embodiment of the present application, and FIG. 2 is an exploded diagram of the electronic device 100 shown in FIG. 1.

In the embodiment of the present application, for ease of illustration, the length direction of the electronic device 100 is a first direction X, the width direction of the electronic device 100 is a second direction Y, the height direction of the electronic device 100 is a third direction Z, and the first direction X, the second direction Y, and the third direction Z are mutually perpendicular to each other in pairs.

The electronic device 100 may include a chassis body 10, a first front frame body 20, a second front frame body 30, a first rear frame body 40, a second rear frame body 50, a board 60, a plurality of fan boards (71, 72), a plurality of functional modules (not shown in the figure), and a plurality of fan modules (not shown in the figure).

The chassis body 10, the first front frame body 20, the second front frame body 30, the first rear frame body 40, and the second rear frame body 50 may jointly form a chassis of the electronic device 100. The chassis body 10 may provide specific accommodation space for modules that constitute the electronic device 100 and structural components that connect the modules, so that the modules jointly constitute a server system in the chassis body 10. Each frame body of the first front frame body 20, the second front frame body 30, the first rear frame body 40, and the second rear frame body 50 may serve as a frame body structure that constitutes the chassis of the electronic device 100. The chassis may be divided into a plurality of frames by disposing each frame body, thereby facilitating assembly, disassembly, and maintenance of the entire electronic device 100. The plurality of functional modules may be one or more combinations of the CPU, the GPU, the TPU, the DPU, the NPU, the BPU, the FPGA, the ASIC, a hard disk module, a power module, or a network interface card. The plurality of fan modules may dissipate heat generated during operation of the electronic device 100, thereby ensuring good uniform heat performance of the electronic device 100. The plurality of fan boards may be electrically connected to the board 60 and the plurality of fan modules, so as to achieve fine control of the plurality of fan modules. A plurality of frame bodies (the first front frame body 20, the second front frame body 30, the first rear frame body 40, and the second rear frame body 50) may be configured to accommodate the plurality of functional modules and the plurality of fan modules. By correspondingly disposing functional modules and fan modules in each frame body structure, the space inside the chassis body 10 may be divided into a plurality of functional zones, so as to achieve reasonable layout of different functional module zones. The board 60 may be configured as a circuit board that achieves an electrical connection among modules in the electronic device 100. Based on a physical connection and an electrical connection between each of the modules and the board 60, the plurality of modules may be integrated and interconnected, thereby enabling the electronic device 100 to achieve multifunctional collaboration.

It should be noted that the structure illustrated in the embodiments of the present application does not construe a specific limitation to the electronic device 100. In other embodiments of the present application, the electronic device 100 may include more or fewer components than the components in the figure, or some components that are combined, or some components that are split apart, or different component arrangements. The components shown in the figure may be implemented by hardware, software, or a combination of software and hardware.

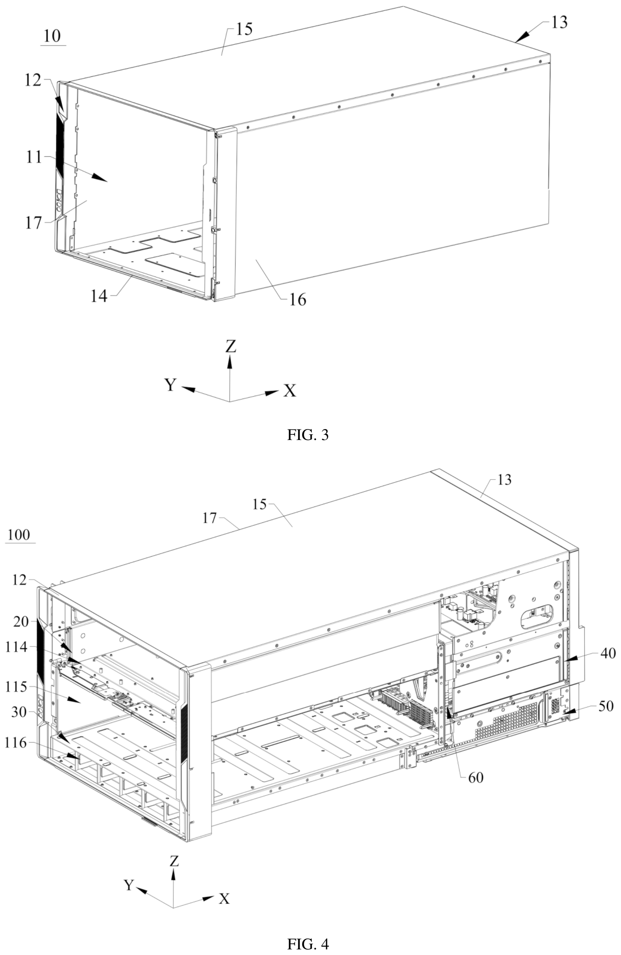

As shown in FIG. 3, FIG. 3 is a structural diagram of the chassis body 10 of the electronic device 100 shown in FIG. 1.

The chassis body 10 has an accommodation space 11, and the accommodation space 11 may be configured to accommodate the first front frame body 20, the second front frame body 30, the first rear frame body 40, the second rear frame body 50, the board 60, the plurality of fan boards, the plurality of functional modules, and the plurality of fan modules. The chassis body 10 includes a front end 12 and a rear end 13, and the front end 12 of the chassis body 10 and the rear end 13 of the chassis body 10 are disposed opposite each other in a first direction X.

The chassis body 10 may include a bottom cover plate 14, a top cover plate 15, a first support plate 16 and a second support plate 17. The bottom cover plate 14 and the top cover plate 15 are disposed opposite each other and spaced apart in the third direction Z, the bottom cover plate 14 extends from the front end 12 of the chassis body 10 to the rear end 13 of the chassis body 10 in the first direction X, the top cover plate 15 also extends from the front end 12 of the chassis body 10 to the rear end 13 of the chassis body 10 in the first direction X. The first support plate 16 and the second support plate 17 are connected between the top cover plate 15 and the bottom cover plate 14, and the first support plate 16 and the second support plate 17 are disposed opposite each other and spaced apart in the second direction Y. The first support plate 16 extends from the front end 12 of the chassis body 10 to the rear end 13 of the chassis body 10 in the first direction X, and the second support plate 17 also extends from the front end 12 of the chassis body 10 to the rear end 13 of the chassis body 10 in the first direction X. The bottom cover plate 14, the first support plate 16, the top cover plate 15, and the second support plate 17 are sequentially connected to enclose and form the accommodation space 11 of the chassis body 10.

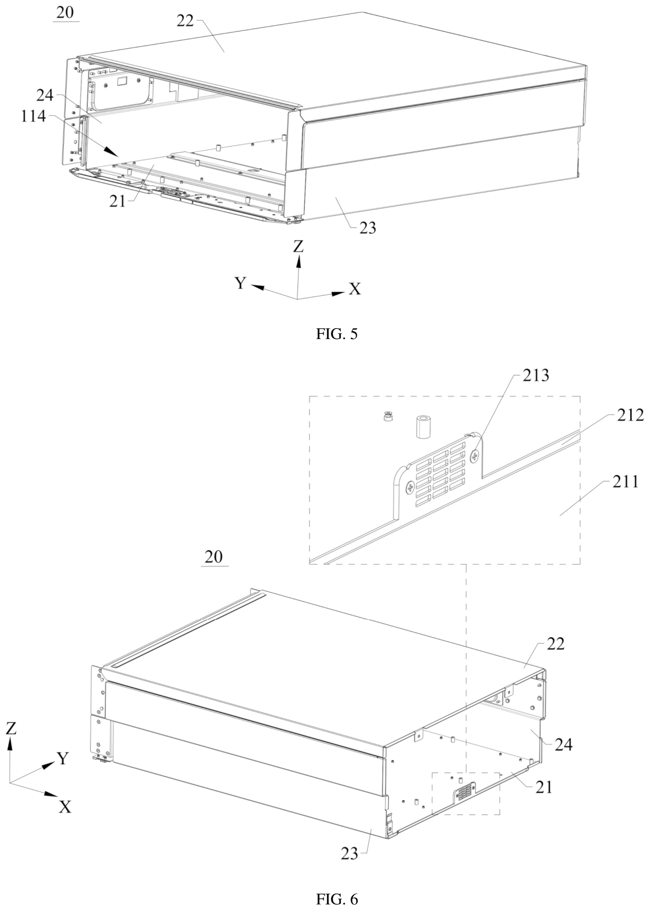

In combination with FIGS. 4, 5, and 6, FIG. 4 is a partial structural diagram of the electronic device 100 shown in FIG. 1, FIG. 5 is a structural diagram of the first front frame body 20 shown in FIG. 1 from a perspective, and FIG. 6 is a structural diagram of the first front frame body 20 shown in FIG. 1 from another perspective. The electronic device 100 shown in FIG. 4 does not show the first support plate 16 and the bottom cover plate 14 of the chassis body 10.

The first front frame body 20 is connected to the front end 12 of the chassis body 10, and the first front frame body 20 extends from the front end 12 of the chassis body 10 to the rear end 13 of the chassis body 10. The first front frame body 20 is connected to the first support plate 16 of the chassis body 10, the second support plate 17 of the chassis body 10, the top cover plate 15 of the chassis body 10, and the board 60. The first front frame body 20 is an internally hollow frame structure, and may cooperate with the chassis body 10 to enclose a first functional zone 114. The first functional zone may be configured to accommodate a plurality of functional modules, and the plurality of functional modules may be a plurality of first functional modules. For example, the first functional module may be a pluggable XPU module. The XPU module may include one or a combination of a CPU module, a GPU module, a TPU module, a DPU module, an NPU module, or a BPU module.

It may be understood that the first front frame body 20 is connected to the top cover plate 15, the first support plate 16, and the second support plate 17 of the chassis body 10, so that the first front frame body 20 may be distributed on an upper part of the chassis body 10. The first front frame body 20 is configured as a frame structure, which not only may facilitate disassembly and assembly of the first front frame body 20 from the chassis body 10 when the electronic device 100 performs operations such as assembly and maintenance, but also may provide a certain space for accommodating the first functional module.

The first front frame body 20 may include a first partition plate 21, a second top plate 22, a third side plate 23, and a fourth side plate 24. The first partition plate 21 is connected to the board 60. The first partition plate 21, the chassis body 10, and the board 60 cooperate to enclose the first functional zone 114. The first functional zone 114 may be configured to accommodate the first functional module. The first partition plate 21 and the second top plate 22 are disposed opposite each other and spaced apart in the third direction Z, the third side plate 23 and the fourth side plate 24 are connected between the first partition plate 21 and the second top plate 22, and the third side plate 23 and the fourth side plate 24 are disposed opposite each other and spaced apart in the second direction Y.

Specifically, the second top plate 22 extends along the first direction X, and the second top plate 22 is connected to the top cover plate 15 of the chassis body 10. The third side plate 23 extends along the first direction X and the third side plate 23 is connected to the first support plate 16 of the chassis body 10. The fourth side plate 24 extends along the first direction X and the fourth side plate 24 is connected to the second support plate 17 of the chassis body 10.

In a possible implementation, the first front frame body 20 may further include a first end plate (not shown in the figure), the first end plate is connected to the first partition plate 21, the second top plate 22, the third side plate 23, and the fourth side plate 24, and the first end plate is located at an end of the first front frame body 20 close to the board 60. The first end plate may include a first end plate body and a first protrusion. The first end plate body is connected to the second top plate 22, the third side plate 23, and the fourth side plate 24, and the first protrusion is connected to a side of the first end plate body away from the second top plate 22. The first protrusion protrudes from the first end plate body along a negative third direction Z, and the first protrusion is configured to be connected to the first partition plate 21.

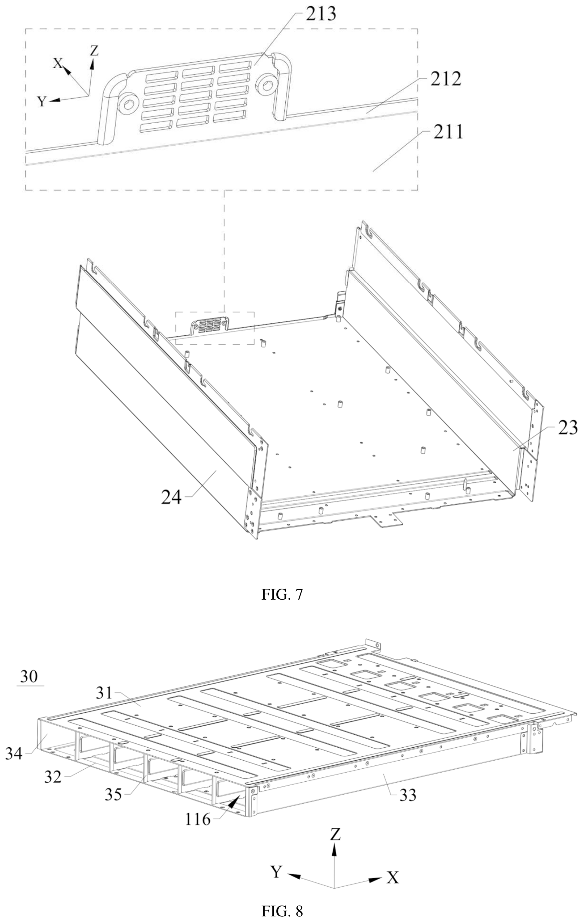

In combination with FIGS. 6 and 7, FIG. 7 is a partial structural diagram of the first front frame body shown in FIG. 6. The first partition plate 21 extends along the first direction X. The first partition plate 21 may include a first partition plate body 211 and a first folded edge 212. The first partition plate body 211 extends along the first direction X, and the first partition plate body 211 is connected between the third side plate 23 and the fourth side plate 24. The first folded edge 212 is connected to an end of the first partition plate body 211 facing the board 60, the first folded edge 212 is arranged at an included angle with the first partition plate body 211, and the first folded edge 212 is configured to be connected to the board 60.

It may be understood that by disposing the first folded edge 212 and arranging the first folded edge 212 at an included angle with the first partition body 211, the first folded edge 212 may be bent relative to the first partition plate body 211, and the bent first folded edge 212 may be connected to the board 60. Compared to directly connecting the partition plate to the board 60, the first folded edge 212 is additionally disposed as a part in the first partition plate 21 connected to the board 60, so that there is a large contact area between the first partition plate 21 and the board 60, which enhances stability and reliability of connection between the first partition 21 and the board 60 when the first front frame body 20 is connected to the board 60.

In a possible implementation, the first partition plate 21 may further include a second protrusion 213. The second protrusion 213 is connected to an end of the first folded edge 212 away from the first partition body 211, the second protrusion 213 extends along the third direction Z, and the second protrusion 213 is configured to be connected to the first protrusion of the first end plate, ensuring good connection performance between the first end plate and the first partition plate 21. The first folded edge 212 and the first end plate body are spaced apart in the third direction Z, so that a gap area between the first folded edge 212 and the first end plate body may provide a mounting space for the structural component.

In addition, the second protrusion 213 may be further provided with a plurality of hole structures that extend through the second protrusion 213 along the first direction X and are spaced apart. The second protrusion 213 presents a grid-like structure. On one hand, the grid-like structure may reduce an amount of material needed for the first partition plate 21. Based on ensuring strength of the first partition plate 21, the grid-like structure provides a channel for connecting components disposed in the first front frame body 20, such as a first functional module, a connector or a structural component, to other modules and/or structural components in the electronic device 100. On the other hand, the grid-like structure may also provide an air channel for connecting the first front frame body 20 to other frame bodies (for example, the first rear frame body 40) in the electronic device 100, so that air in the first front frame body 20 may flow into the other frame bodies, or air in the other frame bodies may flow into the first front frame body 20, so as to achieve overheating exchange between the first front frame body 20 and other frame bodies, which is beneficial to enhancing heat dissipation performance of the electronic device 100.

Based on the above description, it should be understood that the first partition plate 21 may serve as a bottom plate of the first front frame body 20 for the modules and the structural components in the first front frame body 20 disposed thereon, and the first partition plate 21 may also serve as an isolation member for isolating accommodation space 11 of the chassis body 10, to isolate an upper area in the chassis body 10 from other areas in the chassis body 10, so as to ensure that the upper area in the chassis body 10 may serve as the first functional zone 114 to accommodate the first functional module.

It should be noted that, the above description uses the first partition plate 21 being a plate body constituting the first front frame body 20 for example. However, the first partition plate 21 may also be a single plate structure, as long as the first partition plate merely needs to isolate space inside the chassis body, which is not strictly limited in the embodiments of the present application.

In combination with FIGS. 4 and 8, FIG. 8 is a structural diagram of the second front frame body 30 of the electronic device 100 shown in FIG. 1. The second front frame body 30 is connected to the front end 12 of the chassis body 10, and the second front frame body 30 extends from the front end 12 of the chassis body 10 to the rear end 13 of the chassis body 10. The first front frame body 30 is connected to the first support plate 16 of the chassis body 10, the second support plate 17 of the chassis body 10, the top cover plate 14 of the chassis body 10, and the board 60. The second front frame body 30 cooperates with the chassis body 10 to enclose a part of a third functional zone 116. The third functional zone 116 may be configured to accommodate a plurality of functional modules, and the plurality of functional modules may be a plurality of third functional modules. For example, the third functional module may be a pluggable power module.

It may be understood that by connecting the second front frame body 30 to the bottom cover plate 14, the first support plate 16, and the second support plate 17 of the chassis body 10, the second front frame body 30 may be distributed at a lower part of the chassis body 10. The second front frame body 30 is configured as a frame structure, which not only may facilitate disassembly and assembly of the second front frame body 30 from the chassis body 10 when the electronic device 100 performs operations such as assembly and maintenance, but also may provide a certain space for accommodating the third functional module.

The second front frame body 30 may include a second partition plate 31, a second bottom plate 32, a fifth side plate 33, a sixth side plate 34, and a plurality of second baffles 35. The second partition plate 31 extends along the first direction X, the second partition plate 31 is connected to the board 60, and the second partition plate 31 is spaced apart from the first partition 21 in the third direction Z. The second partition plate 31, the chassis body 10, and the board 60 cooperate to enclose a part of the third functional zone 116. (In the following, the board 60, a first top plate 51, and the chassis body 10 encloses another part of the third functional zone 116). The second bottom plate 32 is connected to the bottom cover plate 14 of the chassis body 10, the second bottom plate 32 extends along the first direction X, and the second bottom plate 32 and the second partition plate 31 are disposed opposite each other and spaced apart in the third direction Z. The fifth side plate 33 is connected to the first support plate 16 of the chassis body 10. The fifth side plate 33 is further connected between the second bottom plate 32 and the second partition plate 31. The fifth side plate 33 extends along the second direction Y. The sixth side plate 34 is connected to the second support plate 17 of the chassis body 10. The sixth side plate 34 is also connected between the second bottom plate 32 and the second partition plate 31. The fifth side plate 33 and the sixth side plate 34 are disposed opposite each other and spaced apart in the second direction Y. The plurality of second baffles 35 are connected between the second baffle 31 and the second bottom plate 32, the plurality of second baffles 35 are spaced apart along the second direction Y, and a gap area between two adjacent second baffles 35 is configured to accommodate one or more third functional modules.

Based on the above description, it should be understood that the second partition plate 31 may serve as a top plate of the second front frame body 30 to seal the top of the second front frame body 30, and the second partition plate 31 may also serve as an isolation member for isolating the accommodation space 11 of the chassis body 10, to isolate a lower area in the chassis body 10 from the other areas in the chassis body 10, so as to ensure that the lower area in the chassis body 10 may serve as the third functional zone 116 to accommodate the third functional module.

It should be noted that, the above description uses the second partition plate 31 being a plate body constituting the second front frame body 30 for example. However, the second partition plate 31 may also be a single plate structure, as long as the second partition plate merely needs to isolate space inside the chassis body, which is not strictly limited in the embodiments of the present application.

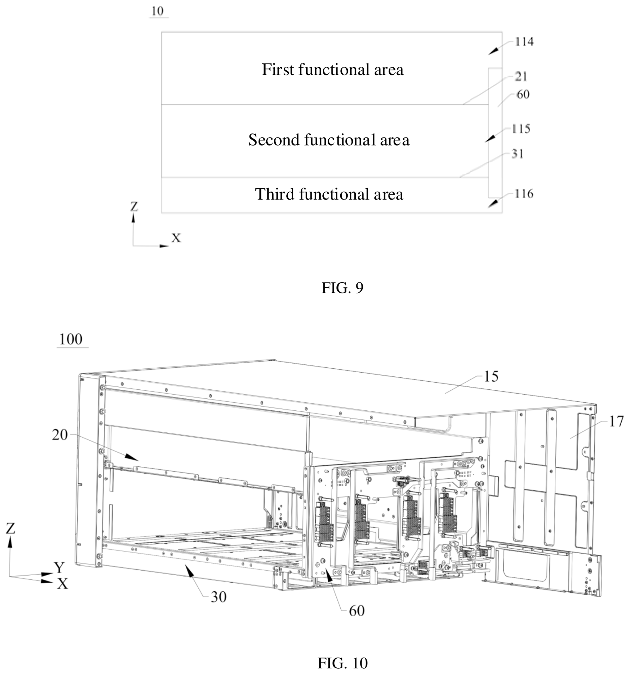

In combination with FIGS. 4 and 9, FIG. 9 is a schematic simplified diagram of division of an internal area of the electronic device 100 shown in FIG. 1. Each functional zone shown in FIG. 9 merely schematically shows a relative position of each functional zone.

The first front frame body 20 may enclose to form a first functional zone 114, the second front frame body 30 may enclose to form a part of the third functional zone 116, and the second front frame body 30 and the first front frame body 20 are spaced apart in the third direction Z. Therefore, a gap area between the second front frame body 30 and the first front frame body 20 may define a second functional zone 115, the second functional zone 115 may be configured for a plurality of functional modules, and the plurality of functional modules may be a plurality of second functional modules. For example, the second functional modules located in the second functional zone 115 may be pluggable CPU modules. In the third direction Z, a height of the first functional zone 114 is greater than a height of the third functional zone 116, and a height of the second functional zone 115 is greater than the height of the third functional zone 116.

It should be understood that, the first front frame body 20 and the second front frame body 30 are disposed at the front end 12 of the chassis body 10, and the second front frame body 30 and the first front frame body 20 are spaced apart in the third direction Z, so that the part of the third functional zone 116 enclosed by the second front frame body 30, the second functional zone 115 formed by spacing the second front frame body 30 apart from the first front frame body 20, and the first functional zone 114 enclosed by the first front frame body 20 may be sequentially disposed along the third direction Z. In other words, based on spacing of the first partition plate 21 and the second partition plate 31, the accommodation space 11 of the chassis body 10 may be properly arranged, so that the first functional zone 114 is distributed in an upper area of the chassis body 10, the second functional zone 115 is distributed in a middle area of the chassis body 10, and the third functional zone 116 is distributed in a lower area of the chassis body 10. The functional zones in the chassis body 10 are independent of each other. In this way, the functional modules are arranged in the corresponding zones more quickly and better based on different functions of the functional zones during assembly of the electronic device 100, resulting in high efficiency and excellent compatibility.

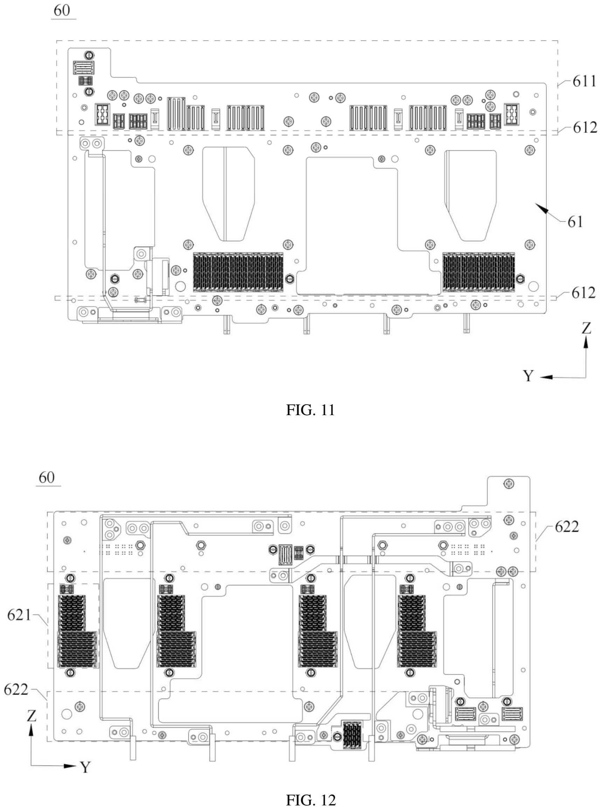

In combination with FIGS. 4, 10, 11, and 12, FIG. 10 is another partial structural diagram of the electronic device 100 shown in FIG. 1, FIG. 11 is a top view of a second surface 62 of the board 60 shown in FIG. 10, and FIG. 12 is a top view of a first surface 61 of the board 60 shown in FIG. 10. The electronic device 100 shown in FIG. 10 does not show the bottom cover plate 14, the first support plate 16, the first front frame body 20, and the second rear frame body 50 of the chassis body 10.

The board 60 is fixedly connected to the chassis body 10, and specifically, opposite ends of the board 60 are respectively connected to the first support plate 16 of the chassis body 10 and the second support plate 17 of the chassis body 10 along the second direction Y. The board 60 is disposed perpendicular to the bottom cover plate 14 of the chassis body 10, and the board 60 extends along the third direction Z. For example, the board 60 may be a high-speed circuit board that supports high-speed signal transmission.

The board 60 may include the first surface 61 and the second surface 62 that are disposed facing away from each other. The first surface 61 of the board 60 is a surface of the board 60 facing the first front frame body 20 and the second front frame body 30, and the second surface 62 of the board 60 is a surface of the board 60 facing the first rear frame body 40 and the second rear frame body 50. The first partition plate 21 in the first front frame body 20 is connected to the first surface 61 of the board 60, the second partition plate 31 in the second front frame body 30 is connected to the first surface 61 of the board 60, the first rear frame body 40 is connected to the second surface 62 of the board 60, and the second rear frame body 50 is connected to the second surface 62 of the board 60. Along the second direction Y, the first front frame body 20 and the second front frame body 30, the board 60, the first rear frame body 40, and the second rear frame body 50 are sequentially disposed.

That is, the first front frame body 20 and the second front frame body 30 are disposed on a side of the board 60, and the first rear frame body 40 and the second rear frame body 50 are disposed on another side of the board 60. Based on a partitioning function of the board 60 in the accommodation space 11, the accommodation space 11 may be divided into two areas: a front area and a rear area. The first front frame body 20 and the second front frame body 30 are located in the front area (that is, the first functional zone 114, the second functional zone 115, and a part of the third functional zone 116 divided by the first front frame body 20 and the second front frame body 30 are located in the front area). The first rear frame body 40 and the second rear frame body 50 are located in the rear area.

The first surface 61 of the board 60 includes a third area 611 and a fourth area 612 that are adjacently disposed. The third area 611 refers to an area in which more components and/or structural components are disposed, and the fourth area 612 refers to an area in which fewer components and/or structural components are disposed; or the fourth area 612 refers to an area in which no component and/or structural component is disposed. For example, the component may be one or a combination of an inductor, a capacitor, a resistor, a connector, an interface, etc., and the structural component may be a screw, a copper bar, etc. There may be a plurality of third areas 611, and there may also be a plurality of fourth areas 612. FIG. 11 only shows one third area 611 and two fourth areas 612 as examples for description. And it should be understood that this is not limited thereto. However, the component and/or the structural component disposed on the first surface 61 in FIG. 11 is merely an example, and does not constitute a limitation to the component and/or the structural component disposed on the first surface 61 of the board 60.

In a possible implementation, the electronic device 100 further includes a second cushioning member (not shown in the figure), the second cushioning member is connected to the first surface 61 of the board 60, the second cushioning member is located in the fourth area 612 of the first surface 61, and the second cushioning member extends along the second direction Y. A surface of the second cushioning member facing away from the board 60 is connected to a first folded edge 212 of the first partition plate 21. That is, the second cushioning member is clamped between the first folded edge 212 of the first partition plate 21 and the board 60. That is, the second cushioning member may be connected to the first partition plate 21 and the board 60. On one hand, the second cushioning member provided between the first folded edge 212 of the first partition plate 21 and the board 60 may absorb the gap and deformation deviation between the first folded edge 212 and the board 60. This ensures good sealing performance between the first partition plate 21 and the board 60, preventing air flowing in the first functional zone 114 from leaking to other functional zones. On the other hand, the second cushioning member provided between the first folded edge 212 of the first partition plate 21 and the board 60, due to its good cushioning property, may also provide shock absorption protection for the first partition plate 21 and the board 60 during assembly, transportation, and maintenance of the electronic device 100, thereby avoiding damage caused by direct impact between the first folded edge 212 and the board 60, and enhancing reliability.

For example, the second cushioning member may be a foam, a rubber, a waterproof rubber pad, etc. Certainly, the second cushioning member is not limited to the types listed above, and a cushioning structure that is continuous, has a predetermined thickness, and is capable of absorbing deformation falls within the scope of protection claimed in the embodiments of the present application.

In a possible implementation, a fourth cushioning member may be further disposed between a second partition plate 31 of the second front frame body 30 and the board 60, that is, the fourth cushioning member may be connected to the second partition board 31 and the board 60, ensuring good sealing performance between the second partition plate 31 and the board 60. A structure of the second partition plate 31 and a connection relationship among the second partition plate 31, the fourth cushioning member, and the board may be configured with reference to a connection relationship between the first partition plate 21 and the second cushioning member, and details are not described herein again.

In the embodiments of the present application, the second surface 62 of the board 60 includes a first area 621 and a second area 622 that are adjacently disposed. The first area 621 refers to an area in which more components and/or structural components are disposed, and the second area 622 refers to an area in which fewer components and/or structural components are disposed; or the second area 622 refers to an area in which no component and/or structural component is disposed. For example, the component may be one or a combination of an inductor, a capacitor, a resistor, a connector, and an interface, etc. The structural component may be a screw, a copper bar, etc. There may be a plurality of first areas 621, and there may also be a plurality of second areas 622. FIG. 12 only shows one first area 621 and two second areas 622 as examples for description. And it should be understood that this is not limited thereto. However, the component and/or the structural component disposed on the second surface 62 in FIG. 12 is merely an example, and does not constitute a limitation to the component and/or the structural component disposed on the second surface 62 of the board 60.

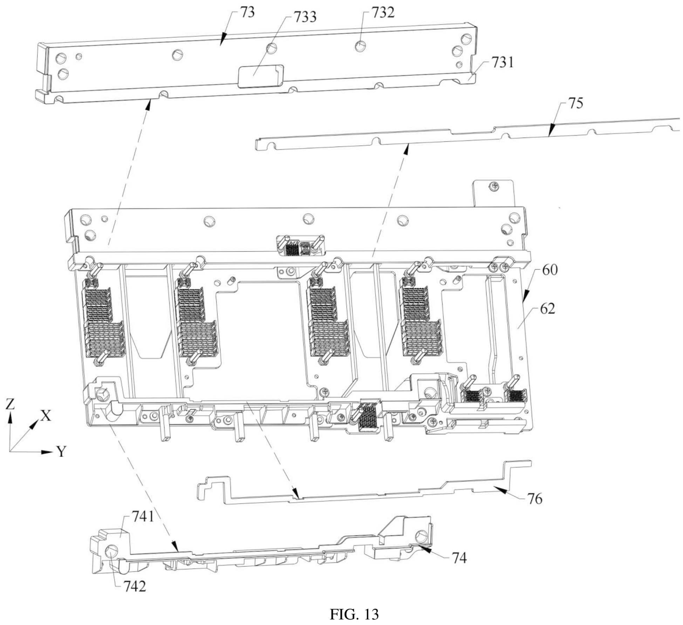

In combination with FIGS. 12 and 13, FIG. 13 is an assembly schematic diagram of the board 60, a first cushioning member 75 and a first insulator 73 shown in FIG. 1. The electronic device 100 may further include the first insulator 73 and the first cushioning member 75.

The first insulator 73 is in a shell shape, the first insulator 73 extends along the second direction Y, the first insulator 73 is fixedly connected to the second surface 62 of the board 60, the first insulator 73 is located in the second area 622 on a side of the second surface 62 close to the first front frame body 20, and the first insulator 73 is connected to the first rear frame body 40. When the first insulator 73 is fixed to the second surface 62 of the board 60, the first insulator 73 protrudes from the second surface 62 of the board 60, and the first insulator 73 may cover a welding point of a conductive bar (for example, a copper bar) provided in the second area 622, as shown in FIG. 12. For example, the first insulator 73 may be made of plastic, ABS (Acrylonitrile Butadiene Styrene, acrylonitrile-butadiene-styrene copolymer) or other insulative and deformation-resistant materials.

In a possible implementation, the electronic device may further include a second insulator 74. As shown in FIG. 13, the second insulator 74 is in a shell shape, the second insulator 74 extends along the second direction Y, the second insulator 74 is fixedly connected to the second surface 62 of the board 60, and the second insulator 74 is located in the second area 622 on a side of the second surface 62 close to the second front frame body 30. In the third direction Z, the second insulator 74 is disposed opposite and spaced apart from the first insulator 73. When the second insulator 74 is fixed to the second surface 62 of the board 60, the second insulator 74 protrudes from the second surface 62 of the board 60, the second insulator 74 is configured to connect the second rear frame body 50, and the second insulator 74 may cover the welding point of the conductive bar (for example, the copper bar) provided in the second area 622, as shown in FIG. 12. For example, the second insulator 74 may be made of plastic, ABS (Acrylonitrile Butadiene Styrene, acrylonitrile-butadiene-styrene copolymer), or other insulative and deformation-resistant materials.

It should be noted that, FIG. 13 merely schematically illustrates shapes of the first insulator 73 and the second insulator 74. Actual shapes of the first insulator 73 and the second insulator 74 may be flexibly adjusted based on a device layout on the board 60, which are not strictly limited in the embodiments of the present application.

It may be understood that the board 60 may integrate circuits, and interconnect modules in the electronic device 100 through high-density routing. However, the board 60 generally implements a current path of the board 60 by configuring a plurality of groups of conductive bars on the board 60. The plurality of groups of conductive bars have a plurality of welding points with the board 60 (for example, a group of conductive bars have at least two welding points with the board 60). In the electronic device 100, the first rear frame body 40 and the second rear frame body 50 that are connected to the board 60 are generally of a metal frame structure. If the frames are directly connected to board 60, the welding points of multiple conductive bar groups are easily connected. Furthermore, the frames may be easily in communication with the welding points of the plurality of groups of conductive bars, resulting in an electrical fault such as a short circuit. Therefore, by disposing the first insulator 73 and the second insulator 74 at the welding points of the plurality of groups of conductive bars can make the welding points be isolated from an external environment. The plurality of welding points of the plurality of groups of conductive bars may be protected, and faults such as short circuits may be avoided due to contact between the first rear frame body 40 and the second rear frame body 50 and the welding points, thereby enhancing electrical reliability.

As shown in FIG. 13, a first mounting slot 731 is recessed in a surface of the first insulator 73 facing away from the board 60, the first mounting slot 731 extends along the second direction Y, and is recessed from the surface facing away from the board 60 towards the board 60, and the first mounting slot 731 is configured to accommodate the first cushioning member 75. The first insulator 73 is further provided with a plurality of first openings 732 for avoiding screw installation, and the plurality of first openings 732 are spaced apart on the first insulator 73. It may be understood that the second surface 62 of the board 60 is uneven. The first insulator 73 is additionally disposed on the second surface 62 of the board 60, the first insulator 73, due to its uniform surface, provides a flat mounting environment for attaching the first cushioning member 75. Therefore, the first cushioning member 75 has good flatness when mounted on the first insulator 73, which is conducive to better exerting operating performance of the first cushioning member 75.

At least a part of the first cushioning member 75 is located in the first mounting slot 731, and the first cushioning member 75 is configured to be connected to the middle layer plate 42 of the first rear frame body 40, and the first cushioning member 75 may isolate the first air channel 111 from the second air channel 112. For example, the first cushioning member 75 may be a foam, a rubber, a waterproof rubber pad, etc. Certainly, the first cushioning member 75 is not limited to the types listed above, and a cushioning structure that is continuous, has a predetermined thickness and is capable of absorbing deformation falls within the scope of protection claimed in the embodiments of the present application.

In a possible implementation, as shown in FIG. 13, the electronic device 100 may further include a third cushioning member 76. A second mounting slot 741 is recessed in a surface of the second insulator 74 facing away from the board 60, the second mounting slot 741 extends along the second direction Y, the second mounting slot 741 is recessed from the surface facing away from the board 60 towards the board 60, and the second mounting slot 741 and the first mounting slot 731 are spaced apart in the third direction Z. The second mounting slot 741 is configured to accommodate the third cushioning member 76. The second insulator 74 is further provided with a plurality of second openings 742 for avoiding screw installation, and the plurality of second openings 742 are spaced apart on the second insulator 74. It may be understood that the second surface 62 of the board 60 is uneven. The second insulator 74 is additionally disposed on the second surface 62 of the board 60, so that the second insulator 74, due to its uniform surface, provides a flat mounting environment for attaching the third cushioning member 76. Therefore, the third cushioning member 76 has good flatness when mounted on the second insulator 74, which is conducive to better exerting operating performance of the third cushioning member 76.

At least a part of the third cushioning member 76 is located in the second mounting slot 741, and the third cushioning member 76 is configured to be connected to a first top plate 51 of a second rear frame body 50 described below, and the third cushioning member 76 may isolate the second air channel 112 from the third air channel 113. For example, the third cushioning member 76 may be a foam, a rubber, a waterproof rubber pad, etc. Certainly, the third cushioning member 76 is not limited to the types listed above, and a cushioning structure that is continuous, has a predetermined thickness, and is capable of absorbing deformation falls within the scope of protection claimed in the embodiments of the present application.

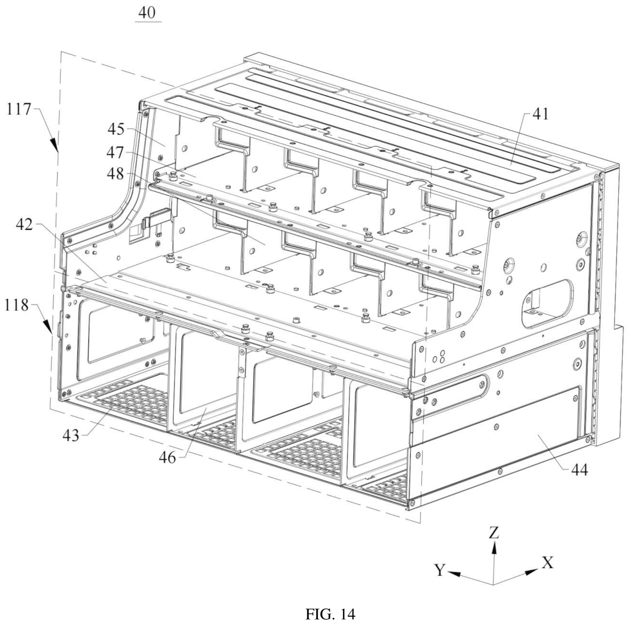

It should be noted that FIG. 13 merely schematically illustrates shapes of the first cushioning member 75 and the third cushioning member 76. Actual shapes of the first cushioning member 75 and the third cushioning member 76 may be flexibly adjusted based on the shapes of the first insulator 73 and the second insulator 74, and merely need to be adapted to edge forms of the first insulator 73 and the second insulator 74, which are not strictly limited in the embodiments of the present application. In combination with FIGS. 4 and 14, FIG. 14 is a structural diagram of the first rear frame body 40 of the electronic device 100 shown in FIG. 1.

The first rear frame body 40 is connected to the rear end 13 of the chassis body 10, and the first rear frame body 40 is detachably connected to the chassis body 10. The first rear frame body 40 is connected to the top cover plate 15 of the chassis body 10, the first support plate 16 of the chassis body 10, the second support plate 17 of the chassis body 10, and the board 60. The first rear frame body 40 may cooperate with the chassis body 10 to enclose a fan zone 117 and a pluggable module zone 118. The fan zone 117 may be configured to accommodate a fan module or a plurality of functional modules, and the plurality of functional modules may be a plurality of first functional modules. The pluggable module zone 118 may be configured to accommodate a fan module or a plurality of functional modules, and the plurality of functional modules may be a plurality of second functional modules. For example, the first functional module located in the fan zone 117 may be a pluggable CPU module, or the second functional module located in the pluggable module zone 118 may be one or a combination of a power module, a hard disk module, or a network interface card that are pluggable. The details will be described below.

It may be understood that the first rear frame body 40 is connected to the top cover plate 15, the first support plate 16, and the second support plate 17 of the chassis body 10, thereby enabling the first rear frame body 40 to be distributed on the upper part of the chassis body 10. The first rear frame body 40 is configured as a frame structure, which not only may facilitate disassembly and assembly of the first front frame body 40 from the chassis body 10 when the electronic device 100 performs operations such as assembly and maintenance, but also may provide a certain space for accommodating the second functional module and the fan module.

In a possible implementation, the first rear frame body 40 is an integrated structural frame that may perform a plug-and-pull action with the chassis body 10 as a whole, so that when the first rear frame body 40 needs to be assembled with the chassis body 10, the first rear frame body 40 may be rapidly assembled to the chassis body 10 and rapidly disassembled from the chassis body 10 when maintenance is needed. For example, a detachable connection may be a connection by means of a clamp or a fastener.

In the embodiments of the present application, the first rear frame body 40 may include an upper layer plate 41, a middle layer plate 42, a lower layer plate 43, a first side plate 44, a second side plate 45, and a plurality of third baffles 46. In the third direction Z, the lower layer plate 43, the middle layer plate 42, and the upper layer plate 41 are sequentially spaced apart. A size of the lower layer plate 43 may be adapted to a size of the middle layer plate 42, and a size of the upper layer plate 41 is less than sizes of the middle layer plate 42 and the lower layer plate 43. The first side plate 44 and the second side plate 45 are respectively connected to opposite sides of the lower layer plate 43, the middle layer plate 42, and the upper layer plate 41 in the second direction Y. The plurality of third baffles 46 are spaced apart in a gap area between the lower layer plate 43 and the middle layer plate 42, each third baffle 46 is connected between the lower layer plate 43 and the middle layer plate 42, and a gap area between two adjacent third baffles 46 may be configured to accommodate a plurality of functional modules. For example, the plurality of functional modules may be a plurality of second functional modules. In a gap area between the two adjacent third baffles 46, the plurality of second functional modules may be disposed along the third direction Z.

The upper layer plate 41, the middle layer plate 42, the first side plate 44, and the second side plate 45 cooperate to enclose the fan zone 117, and the middle layer plate 42, the first side plate 44, and the second side plate 45 cooperate to enclose the pluggable module zone 118. In the third direction Z, the pluggable module zone 118 and the fan zone 117 are sequentially arranged and are independent of each other. The fan zone 117 is isolated from the pluggable module zone 118, the fan zone 117 is in communication with the first functional zone 114, and the pluggable module zone 118 is connected to the second functional zone 115.

It may be understood that, by properly arranging relative positions of plates in the first rear frame body 40, an upper area of the first rear frame body 40 may integrate a fan module or a functional module, and a lower area of the first rear frame body 40 may integrate a functional module or a fan module. Thus, the first rear frame body 40 is divided into two independent functional zones i.e. the fan zone 117 and the pluggable module zone 118. In other words, the first rear frame body 40 may integrate a plurality of modules with different functions, so that performance of the first rear frame body 40 may be diversified, which is beneficial to multi-scenario application of the first rear frame body 40.

In a possible implementation, as shown in FIG. 14, the first rear frame body 40 may further include a clamping plate 47 and a plurality of first baffles 48. Both ends of the clamping plate 47 are respectively connected to the first side plate 44 and the second side plate 45, and along a height direction of the electronic device 100, the clamping plate 47 is located between the upper layer plate 41 and the lower layer plate 43, and is spaced apart from the upper layer plate 41 and the lower layer plate 43. The plurality of first baffles 48 are spaced apart in a gap area between the upper layer plate 41 and the clamping plate 47 and a gap area between the clamping plate 47 and the middle layer plate 42. Specifically, in the gap area between the upper layer plate 41 and the clamping plate 47, the plurality of first baffles 48 are spaced apart along the second direction Y, each first baffle 48 is connected between the upper layer plate 41 and the clamping plate 47, and a gap area between two adjacent first baffles 48 is configured to accommodate a fan of the fan module. In the gap area between the clamping plate 47 and the middle layer plate 42, the plurality of first baffles 48 are spaced apart along the second direction Y, and each first baffle 48 is connected between the clamping plate 47 and the middle layer plate 42, and the gap area between two adjacent first baffles 48 is configured to accommodate a fan of the fan module. For example, ten fans may be accommodated in the fan zone 117.

It may be understood that, by disposing the clamping plate 47 between the upper layer plate 41 and the middle layer plate 42, the fan zone 117 of the first rear frame body 40 may be divided by the clamping plate 47 into two layers of areas i.e. an upper layer area and a lower layer area. The upper layer area may be configured to accommodate a plurality of fans, and the lower layer area may also accommodate a plurality of fans. In this way, as many fans as possible may be arranged in a limited space layout, which is conducive to improving space utilization of the first rear frame body 40 and heat dissipation performance of the electronic device 100.

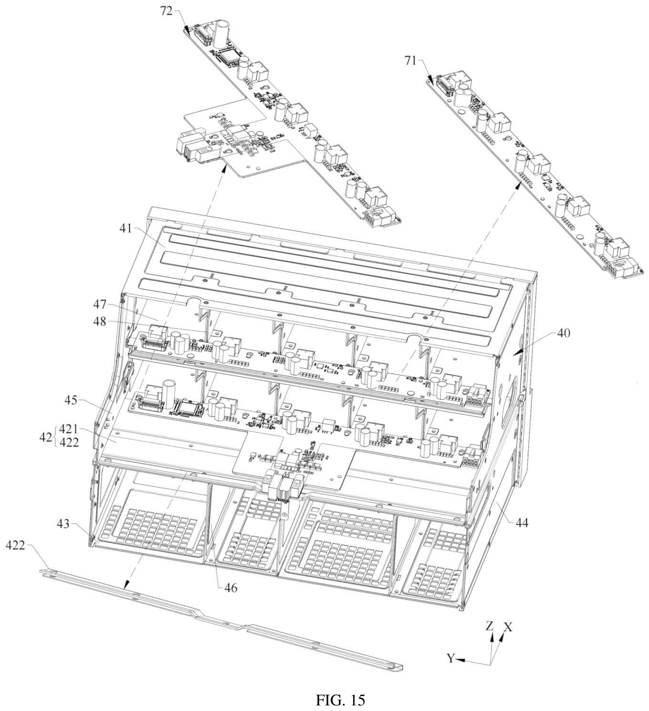

In combination with FIGS. 14 and 15, FIG. 15 is an assembly schematic diagram of a first fan board 71, a second fan board 72 and the first rear frame body 40 of the electronic device 100 shown in FIG. 1. In the implementation, the electronic device 100 may further include the first fan board 71 and the second fan board 72. The first fan board 71 is a circuit board capable of controlling on and off of a plurality of fans located between the upper layer plate 41 and the clamping plate 47. The second fan board 72 is a circuit board capable of controlling on and off of a plurality of fans located between the clamping plate 47 and the middle layer plate 42.

The first fan board 71 is fixed to the clamping plate 47, the first fan board 71 is spaced apart from each of the plurality of first baffles 48 connected between the upper layer plate 41 and the clamping plate 47, and the first fan board 71 is electrically connected to the plurality of fans located between the upper layer plate 41 and the clamping plate 47. For example, the first fan board 71 may be strip-shaped.

The second fan board 72 is fixedly connected to the middle layer plate 42, the second fan board 72 is spaced apart from each of the plurality of the first baffles 48 connected between the clamping plate 47 and the middle layer plate 42, and the second fan board 72 is electrically connected to the plurality of fans located between the clamping plate 47 and the middle layer plate 42. In combination with FIGS. 13 and 15, the first insulator 73 is further provided with a through hole 733, and the through hole 733 passes through the first insulator 73 along the first direction X. One end of the second fan board 72 extending out of the middle layer plate 42 passes through the through hole 733 of the first insulator 73 and is connected to the board 60, and the second fan board 72 is electrically connected to the first fan board 71 and the board 60.

It may be understood that the first fan board 71 may independently control a plurality of fans located at an upper layer of the fan zone 117, the second fan board 72 may independently control a plurality of fans located at a lower layer of the fan zone 117, and the second fan board 72 is further electrically connected between the first fan board 71 and the board 60. Therefore, by using the board 60, fine control may be performed on the plurality of fans located at the upper layer of the fan zone 117 and/or the plurality of fans located at the lower layer of the fan zone 117. That is, by independently controlling the fan module located in the fan zone 117, a quantity of fans adapted to corresponding heat dissipation requirements may be configured based on temperature in the chassis body 10, thereby achieving precise speed adjustment and heat dissipation capability upgrade of the fan module.

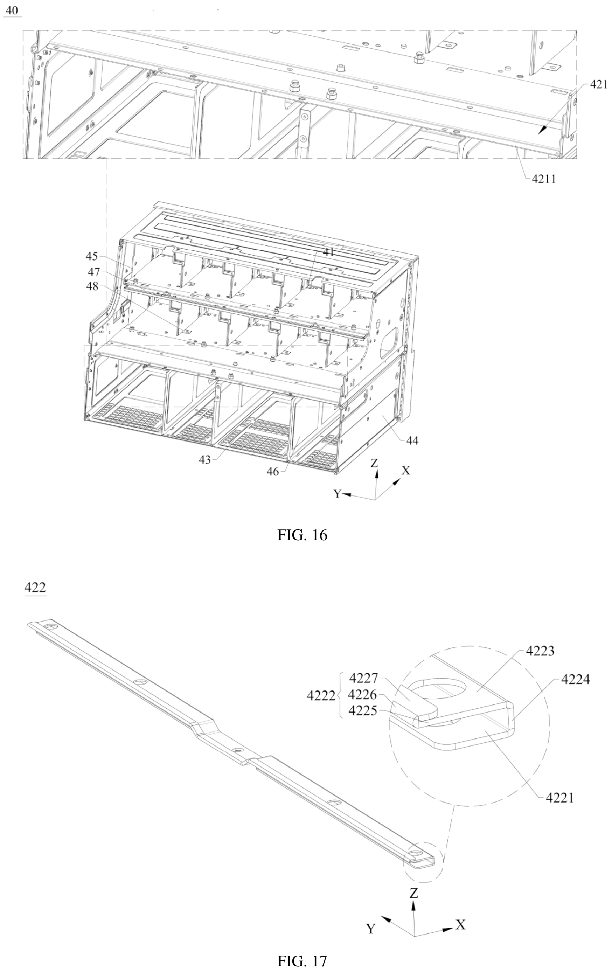

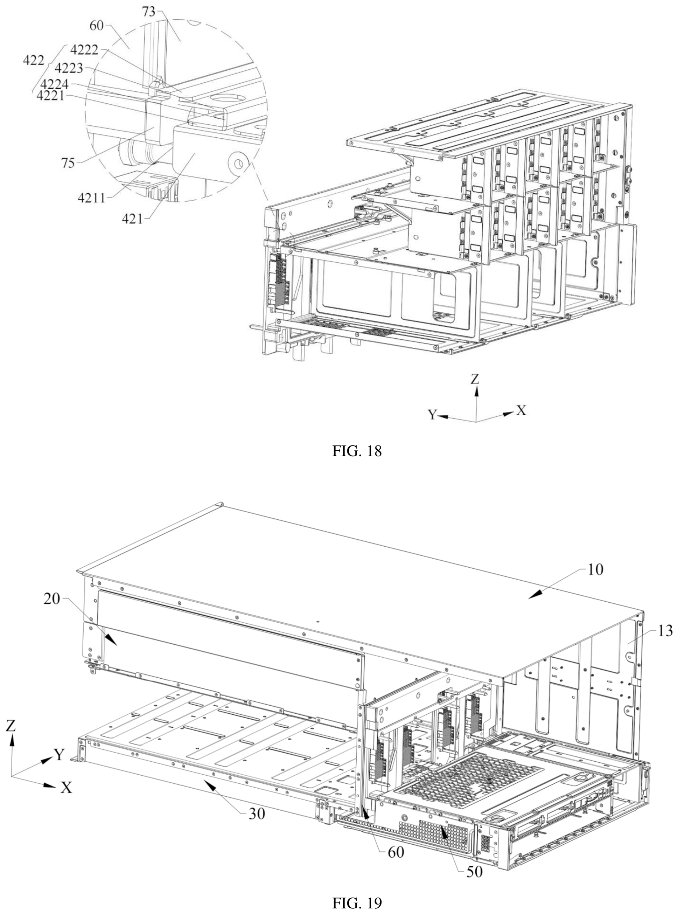

In combination with FIGS. 15, 16, 17, and 18, FIG. 16 is a structural diagram of a base plate 421 of the middle layer plate 42 of the first rear frame body 40 shown in FIG. 14, FIG. 17 is a structural diagram of a connecting member 422 of the middle layer plate 42 of the first rear frame body 40 shown in FIG. 15, and FIG. 18 is a structural diagram of the connecting member 422 of FIG. 17 and the first cushioning member 75. In the embodiments of the present application, the first rear frame body 40 is connected by the middle layer plate 42 to the first cushioning member 75 disposed on the board 60. The middle layer plate 42 may include a base plate 421 and a connecting member 422.

Opposite ends of the base plate 421 along the second direction Y are respectively connected to a first side plate 44 and a second side plate 45. The base plate 421 may include a first side edge 4211 facing the board 60. In the second direction Y, the first cushioning member 75 connected to the board 60 is spaced apart from the first side edge 4211 of the base plate 421, that is, there is a gap between the first cushioning member 75 and the base plate 421. For example, the gap between the first cushioning member 75 and the base plate 421 may be 2-3 mm (including end point values 2mm and 3mm).

In the second direction Y of the electronic device 100, a length of the connecting member 422 may be greater than or equal to a length of the first side edge 4211. For example, the length of the connecting member 422 may be equal to the length of the first side edge 4211, and the connecting member 422 may extend from one end of the first side edge 4211 to the other end of the first side edge 4211. The connecting member 422 includes a first connecting part 4221 and a second connecting part 4222 located at both ends of the connecting member 422. The first connecting part 4221 is fixed to the first side edge 4211 of the base plate 421, the second connecting part 4222 protrudes from the first side edge 4211 of the base plate 421 in a negative first direction X, and the second connecting part 4222 is connected to the first cushioning member 75.

It may be understood that since there is a gap between the first cushioning member 75 and the first side edge 4211 of the base plate 421, air above the middle layer plate 42 easily flow from the gap between the first cushioning member 75 and the first side edge 4211 of the base plate 421 to below the middle layer plate 42 (from a first air channel 111 to a second air channel 112 described below), or air below the middle layer plate 42 flows from the gap between the first cushioning member 75 and the first side edge 4211 of the base plate 421 to below the middle layer plate 42 (from a second air channel 112 to a first air channel 111 described below). Therefore, air channels in the electronic device 100 are mixed with each other. In this way, heat dissipation balance of the electronic device is broken due to uneven air volume matching between the first air channel 111 and the second air channel 112, and high temperature is prone to occur at a local position in the electronic device 100. By disposing the connecting member 422 and extending the connecting member 422 all the way to the first cushioning member 75, on one hand, the first cushioning member 75 may absorb the gap and deformation deviation between the middle layer plate 42 and the board 60. This ensures good air tightness performance between the middle layer plate 42 and the board 60, preventing air on one side of the middle layer plate 42 from leaking to the other side of the middle layer plate 42, thereby maintaining uniform temperature in the electronic device 100, and enhancing heat dissipation performance of the electronic device 100. On the other hand, by extending the connecting member 422 of the middle layer plate 42 to the first cushioning member 75, the first cushioning member 75, due to its good cushioning property, may provide shock absorption protection for the middle layer plate 42 and the board 60 during assembly, transportation, and maintenance of the electronic device 100, thereby avoiding damage caused by direct impact between the middle layer plate 42 and the board 60, and enhancing reliability.

In addition, since the connecting part 422 is detachably connected to the base plate 421, when the connecting part 422 is disassembled from the base plate 421, the board 60 may be exposed, so as to facilitate maintenance of the board 60 and achieve maintainability of the board 60. For example, the detachable connection may be a connection by a screw.

In a possible implementation, in the third direction Z, the first connecting part 4221 is flush with the second connecting part 4222, that is, the connecting part 422 extends horizontally along the first direction X. The first cushioning member 75 may be disposed corresponding to the first side edge 4211 of the base plate 421.

In another possible implementation, in the third direction Z, at least a part of the second connecting part 4222 is higher than the first connecting part 4221. That is, at least the part of the second connecting part 4222 is closer to a top cover plate 15 of the chassis body 10 than the first connecting part 4221. In the first direction Z, at least a part of the first cushioning member 75 may be disposed offset with the first side edge 4211 of the base plate 421, or the first cushioning member 75 is disposed corresponding to the first side edge 4211 of the base plate 421, and the part of the first cushioning member 75 corresponding to the first side edge 4211 of the base plate 421 is provided with an avoidance hole (for example, a hole for a screw to pass through).

For example, in combination with FIGS. 17 and 18, the connecting member 422 may further include a first bent part 4223 and a second bent part 4224. The first connecting part 4221 is arranged in parallel to and spaced apart from the first bent part 4223. The second bent part 4224 is connected between the first connecting part 4221 and the first bent part 4223, and the second bent part 4224 is arranged at an included angle with the first connecting part 4221 and the first bent part 4223. One end of the first bent part 4223 away from the second bend 4224 is connected to the second connecting part 4222. That is, the first connecting part 4221, the second bent part 4224, the first bent part 4223, and the second connecting part 4222 are connected sequentially to form a connecting member 422 having a predetermined height. In this configuration, the connecting member 422, by adjusting its own height, may adapt to a situation where the first side edge 4211 and the first cushioning member 75 fail to be directly aligned due to a height difference in the third direction Z, so that the connecting member 422 may extend to the first cushioning member 75 and abut against the first cushioning member 75. Alternatively, the connecting member 422, by adjusting its own height, may avoid an avoidance notch provided in the first cushioning member 75, so that the connecting member 422 may contact a complete plane of the first cushioning member 75, which further enhances sealing performance between the first cushioning member 75 and the middle layer plate 42.

As shown in FIG. 17, a part of the second connecting part 4222 and the first bend part 4223 may be further directly connected to the first side edge 4211 of the base plate 421, so that the part of the second connecting part 4222 is arranged flush with the first connecting part 4221. In this way, a certain space may be avoided for a device connected to the middle layer plate 42 at this position, and a component connected to the middle layer plate 42 is connected to the board 60. For example, the component may be the second fan board 72.

In the implementation, in combination with FIGS. 17 and 18, the second connecting part 4222 may further include a first section 4225, a bent section 4226, and a second section 4227, the second section 4227 and the first section 4225 are stacked (including a situation where the second section 4227 is located between the first section 4225 and the first connecting part 4221 in the third direction Z and a situation where the second section 4227 is located on a side of the first section 4225 away from the first connecting portion 4221). The bent section 4226 is bent and connected between the first section 4225 and the second section 4227, the bent section 4226 is in contact with the first cushioning member 75, and a thickness of the second connecting section 4222 is greater than a thickness of the first connecting section 4221. In this configuration, the bent section 4226 and the second section 4227 may together form an upward or downward folded edge structure relative to the first section 4225. On one hand, the folded edge structure may increase a contact area with the first cushioning member 75, and ensure good contact stability and reliability between the middle layer plate 42 and the first cushioning member 75. On the other hand, the folded edge structure may increase strength of the second connecting part 4222, so that the second connecting part 4222 is not easily damaged. For example, a surface of the bent section 4226 in contact with the first cushioning member 75 may be an arc surface.

Based on the above description, it should be understood that since the middle layer plate 42 is connected to the first cushioning member 75, the middle layer plate 42 may serve as a partition plate for isolating the fan zone 117 in the first rear frame body 40 from the pluggable module zone 118. The fan zone 117 in the first rear frame body 40 is isolated from the pluggable module zone 118 in the first rear frame body 40, so as to ensure that air between the fan zone 117 in the first rear frame body 40 and the pluggable module zone 118 in the first rear frame body 40 does not flow with each other.

It should be noted that, the above description uses the middle layer plate 42 being a plate body constituting the first rear frame body 40 for example. However, the middle layer plate 42 may also be a single plate structure, as long as the middle layer plate 42 merely needs to isolate space inside the chassis body, which is not strictly limited in the embodiments of the present application.

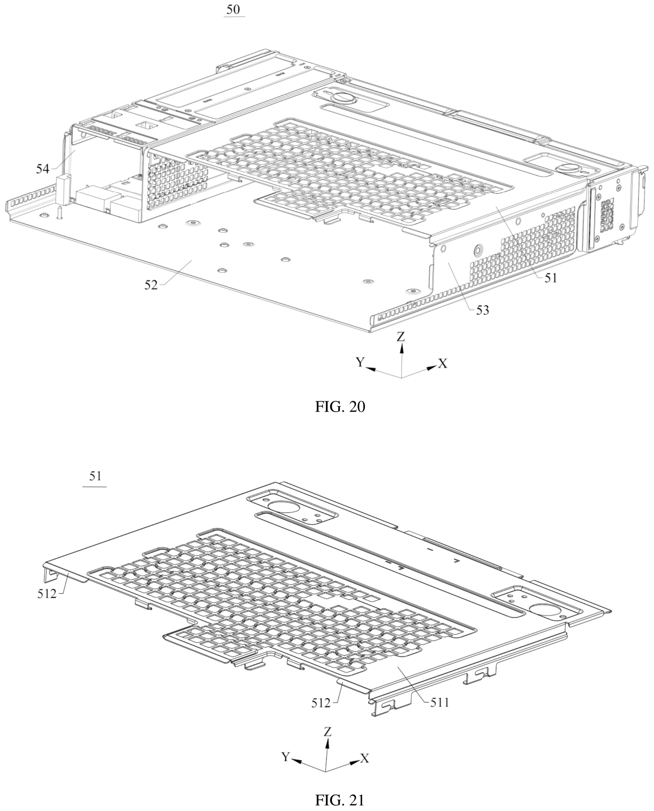

In combination with FIGS. 4, 19, and 20, FIG. 19 is another partial structural diagram of the electronic device 100 shown in FIG. 1, and FIG. 20 is a structural diagram of the second rear frame body 50 of the electronic device 100 shown in FIG. 1.

The second rear frame body 50 is connected to the rear end 13 of the chassis body 10, and the second rear frame body 50 is connected to the bottom cover plate 14 of the chassis body 10, the first support plate 16 of the chassis body 10, the second support plate 17 of the chassis body 10, and the board 60. In the first direction X, the second rear frame body 50 and the first rear frame body 40 are sequentially arranged. The second rear frame body 50 cooperates with the chassis body 10 to enclose another part of the third functional zone 116. Thus, the third functional zone 116 may extend from the front end 12 of the chassis body 10 to the rear end 13 of the chassis body 10. It may be understood that by connecting the second rear frame body 50 to the bottom cover plate 14, the first support plate 16, and the second support plate 17 of the chassis body 10, the second rear frame body 50 may be distributed at the lower part of the chassis body 10. The second rear frame body 50 is configured as a frame structure, which not only may facilitate disassembly and assembly of the second front frame body 30 from the chassis body 10 when the electronic device 100 performs operations such as assembly and maintenance, but also may provide a certain space for accommodating the third functional module. For example, the third functional module may be a power module.

The second rear frame body 50 may include a first top plate 51, a first bottom plate 52, a seventh side plate 53, and an eighth side plate 54. The first top plate 51 extends along the first direction X, the first top plate 51 is connected to the board 60, and the first top plate 51 and the lower layer plate 43 are sequentially arranged in the third direction Z. The first bottom plate 52 is connected to the bottom cover plate 14 of the chassis body 10, the first bottom plate 52 extends along the first direction X, and the first bottom plate 52 and the first top plate 51 are disposed opposite each other and spaced apart in the third direction Z. The seventh side plate 53 is connected to the first support plate 16 of the chassis body 10, the seventh side plate 53 is further connected between the first bottom plate 52 and the first top plate 51, and the seventh side plate 53 extends along the second direction Y. The eighth side plate 54 is connected to the second support plate 17 of the chassis body 10, and the eighth side plate 54 is connected between the first bottom plate 52 and the first top plate 51. The seventh side plate 53 and the eighth side plate 54 are disposed opposite each other and spaced apart in the second direction Y.

Based on the above description, it should be understood that the first top plate 51 may be used as a top plate of the second rear frame body 50 to seal the top of the second rear frame body 50, and the first top plate 51 may also be used as an isolation member for isolating the accommodation space 11 of the chassis body 10, to isolate the lower area in the chassis body 10 from the other areas in the chassis body 10.

It should be noted that, the above description uses the first top plate 51 being a plate body constituting the second rear frame body 50 for example. However, the first top plate 51 may also be a single plate structure, as long as the first top plate 51 merely needs to isolate space inside the chassis body, which is not strictly limited in the embodiments of the present application.

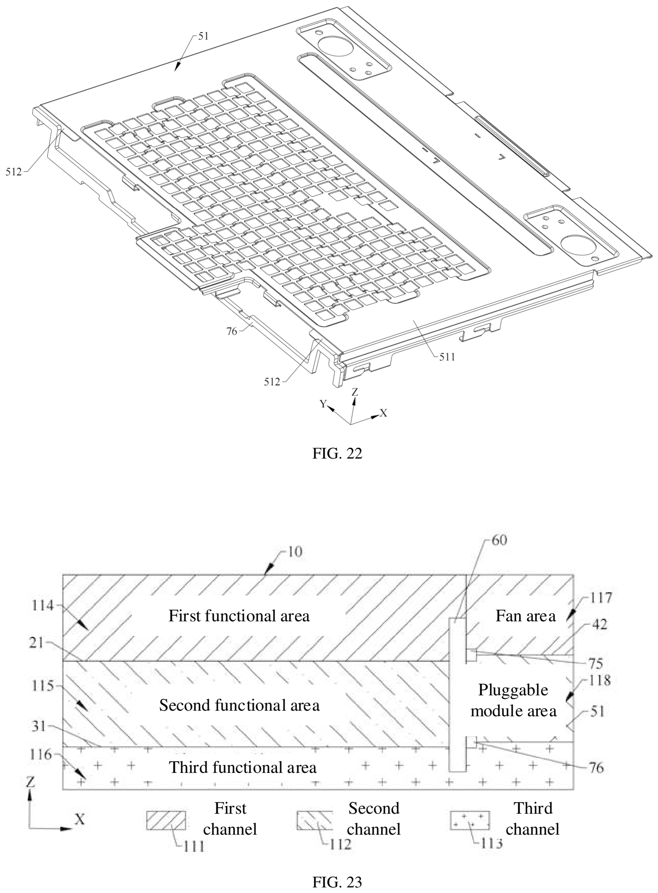

In a possible implementation, in combination with FIGS. 21 and 22, FIG. 21 is a structural diagram of the first top plate 51 of the first rear frame body 40 shown in FIG. 20, and FIG. 22 is a structural diagram of the first top plate 51 of the first rear frame body 40 connected to the third cushioning member 76 shown in FIG. 20. The first top plate 51 may include a first top plate body 511 and an extension edge 512. One end of the extension edge 512 is fixedly connected to the first top plate body 511, the other end of the extension edge 512 extends along a direction away from the first top plate body 511 and is connected to the third cushioning member 76, and the extension edge 512 is arranged at an included angle with the first top plate body 511. For example, as shown in FIG. 21, there may be two extension edges 512, and the two extension edges 512 are respectively provided on both sides of the first top plate body 511 along the second direction Y. For example, the third cushioning member 76 may connect the first top plate 51 to the board 60.

On one hand, the third cushioning member 76 may absorb the gap and deformation deviation between the first top plate 51 and the board 60. This ensures good sealing performance between the first top plate 51 and the board 60. On the other hand, by extending the extension edge 512 to the third cushioning member 76, during assembly, transportation, and maintenance of the electronic device 100, the third cushioning member 76, due to its good cushioning property, may provide shock absorption protection for the top layer plate 51 and the board 60, thereby avoiding damage caused by direct impact between the first top plate 51 and the board 60, and enhancing reliability.

It may be understood that, at the rear end 13 of the chassis body 10, based on spacing of the middle layer plate 42 and the first top plate 51, the accommodation space 11 of the chassis body 10 may be properly arranged, so that a fan zone 117 is distributed in an upper area of the chassis body 10, a pluggable module zone 118 is distributed in a middle area of the chassis body 10, and a third functional zone 116 is distributed in a lower area of the chassis body 10. In this way, each functional zone in the chassis body 10 is independent of each other, so that functional modules may be arranged in corresponding zones based on different functions of the functional zones during assembly of the electronic device 100, resulting in high efficiency and excellent compatibility.

As shown in FIG. 23, FIG. 23 is another schematic simplified diagram of division of an internal area of the electronic device 100 shown in FIG. 1. FIG. 23 merely schematically illustrates a relative position of each area in the chassis body 10.

In the embodiment of the present application, the accommodation space 11 includes a first air channel 111, a second air channel 112, and a third air channel 113. The third air channel 113, the second air channel 112, and the first air channel 111 are sequentially arranged along the third direction Z. It may be understood that, with the board 60 as a dividing line, a first partition plate 21 and a second partition plate 31 that are connected to one side of the board 60, may divide space on one side of the board 60 into the first functional zone 114 located in the upper area of the chassis body 10, the second functional zone 115 located in the middle area of the chassis body 10 and a part of the third functional zone 116 located in the lower area of the chassis body 10. The middle layer plate 42 and the first top plate 51 connected to the other side of the board 60 may divide space on the other side of the board 60 into the fan zone 117 located in the upper area of the chassis body 10, the pluggable module zone 118 located in the middle area of the chassis body 10 and another part of the third functional zone 116 located in the lower area of the chassis body 10. The first functional zone 114 and the fan zone 117 are in communication with each other, the first functional zone 114 and the fan zone 117 are located in the first air channel 111, the second functional zone 115 and the pluggable module zone 118 are in communication with each other, the second functional zone 115 and the pluggable module zone 118 are located in the second air channel 112, and the third functional zone 116 is located in the third air channel 113.

Since one side of the board 60 is connected to the first partition plate 21 and the second partition plate 31, the other side of the board 60 is connected to the middle layer plate 42 through the first cushioning member 75 and connected to the first top plate 51 through the third cushioning member 76. The first partition plate 21, the board 60, the first cushioning member 75, and the middle layer plate 42 may cooperate to isolate the first air channel 111 from the second air channel 112. The second partition plate 31, the board 60, the third cushioning member 76, and the first top plate 51 may cooperate to isolate the second air channel 112 from the third air channel 113. That is, the first air channel 111 and the second air channel 112 are isolated by the first partition plate 21, the board 60, the first cushioning member 75, and the middle layer plate 42. The second air channel 112 and the third air channel 113 are isolated by the second partition plate 31, the board 60, the third cushioning member 76, and the first top plate 51.

In this configuration, the first air channel 111, the second air channel 112, and the third air channel 113 are arranged independently of each other, the first air channel 111, the second air channel 112, and the third air channel 113 may be isolated from each other because they are not in communication with each other. In this way, air flow in the first air channel 111, the air flow in the second air channel 112, and air flow in the third air channel 113 may not produce adverse effects caused by mutual mixing, thereby significantly reducing occurrence of problems such as air volume bypass or air leakage to a low-resistance one due to unmatched resistance. In addition, cold air in the first air channel 111 only dissipates heat from a module located in the first air channel 111, and cold air in the second air channel 112 only dissipates heat from a module located in the second air channel 112, and cold air in the third air channel 113 only dissipates heat from a module located in the third air channel 113. Therefore, air volume matching and heat dissipation capability upgrade may be performed according to heat dissipation requirements of modules in respective air channels, which helps improve overall heat dissipation performance of the electronic device 100.

It should be noted that, in the third air channel 113, a small built-in fan may be provided in the third functional module to blow air, and a flow direction of the third air channel 113 may be consistent with a flow direction of the second air channel 112. Since the third air channel 113 has a relatively small air volume and a relatively low air speed, and the second air channel 112 has a relatively large air volume and a relatively large air speed, in order to prevent air outlet of the second air channel 112 from affecting air outlet of the third air channel 113, the second air channel 112 is isolated from the third air channel 113. The following is described by using an example in which the plurality of fan modules are disposed in the first air channel 111 and the second air channel 112, and it should be understood that this is not limited thereto.

In the embodiment of the present application, the plurality of fan modules may include a first fan module and a second fan module. The first fan module is disposed in the first air channel 111, and the first fan module is configured to dissipate heat from the module in the first air channel 111. The second fan module is disposed in the second air channel 112, and the second fan module is configured to dissipate heat from a module in the second air channel 112. The first fan module and the second fan module may be disposed on a same side of the plate 60, or the first fan module and the second fan module may be disposed on different sides of the board 60. It may be understood that by disposing the fan module inside the chassis body 10, pluggable space occupied by the fan module on a panel of the electronic device 100 may be reduced, so that the part of space may be used for arranging more pluggable modules, thereby increasing a quantity of the pluggable modules in the electronic device 100. For example, the pluggable module may be a hard disk module.

In a possible implementation, the first fan module and the second fan module are disposed on a side of the first surface 61 of the board 60. For example, the first fan module is located in the first functional zone 114, and the second fan module is located in the second functional zone 115. In this configuration, more pluggable modules may be flexibly arranged, and a negative air pressure of a system caused by the plurality of fan modules being disposed at front and rear ends 13 of the chassis body 10 may be avoided, which is conducive to enhancing a heat dissipation effect of the electronic device 100.

In another possible implementation, the first fan module and the second fan module are disposed on a side of the second surface 62 of the board 60. For example, the first fan module is located in the fan zone 117, and the second fan module is located in the pluggable module zone 118. In this configuration, more pluggable modules may be flexibly arranged, and a negative air pressure of a system caused by the plurality of fan modules being relatively disposed at the front and rear ends 13 of the chassis body 10 may be avoided, which is conducive to enhancing a heat dissipation effect of the electronic device 100.

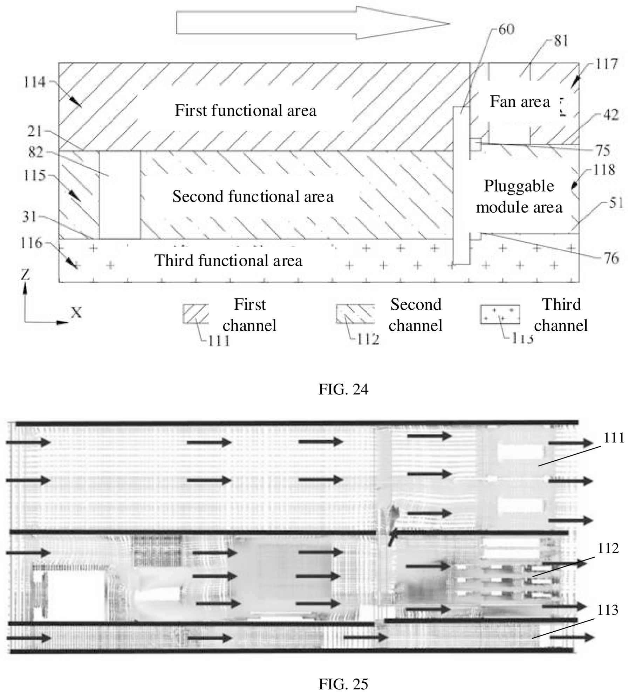

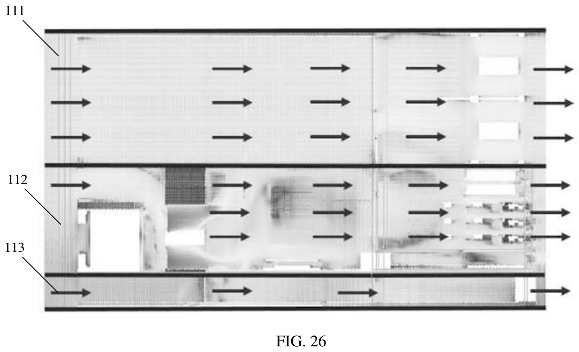

In another possible implementation, the first fan module 81 and the second fan module 82 may be disposed on different sides of the board 60. For example, in combination with FIGS. 24, 25, and 26, FIG. 24 is another schematic simplified diagram of division of an internal area of the electronic device 100 shown in FIG. 1, FIG. 25 is a schematic diagram of an air channel flow direction when the first air channel 111 and the second air channel 112 are not completely isolated from each other as shown in FIG. 24, and FIG. 26 is a schematic diagram of an air channel flow direction when the first air channel 111 and the second air channel 112 are completely isolated from each other as shown in FIG. 24. Arrows in FIG. 24 represent system air directions of the electronic device 100, and arrows in FIGS. 25 and 26 represent air channel flow directions.

In the implementation, the first fan module 81 is located in the fan zone 117, and the second fan module 82 is located in the second functional zone 115. That is, the first fan module 81 is located at the rear end 13 of the chassis body 10, and the second fan module 82 is located at the front end 12 of the chassis body 10. It may be understood that, a fan of the first fan module 81 is configured to "blow air". Air pressure in the first air channel 111 is "negative pressure" relative to atmospheric pressure. A fan of the second fan module 82 is configured to "exhaust air". Air pressure in the second air channel 112 is "positive pressure" relative to atmospheric pressure. As shown in FIG. 25, if there is a gap between the first air channel 111 and the second air channel 112, air in the second air channel 112 directly flows to the first air channel 111, so that the first air channel 111 and the second air channel 112 are connected and coupled to each other, thereby causing air volume bypass or air leakage, resulting in poor heat dissipation in the second air channel 112. For example, the lower right part shown in FIG. 25 may easily cause overheating.

Based on this, as shown in FIG. 26, the first air channel 111 and the second air channel 112 are completely isolated from each other, so that a "positive pressure" air channel (the second air channel 112) and a "negative pressure" air channel (the first air channel 111) in the electronic device 100 may exist simultaneously. Therefore, modules located in the first air channel 111 and the second air channel 112 may perform normal heat dissipation, which helps ensure temperature uniformity of the electronic device 100 and heat dissipation performance of the electronic device 100.

In another possible implementation, the first fan module 81 and the second fan module 82 may be disposed on different sides of the board 60. For example, the first fan module 81 is located in the first functional zone 114, and the second fan module 82 is located in the pluggable module zone 118. That is, the first fan module 81 is located at the front end 12 of the chassis body 10, and the second fan module 82 is located at the rear end 13 of the chassis body 10. It may be understood that, a fan of the first fan module 81 is configured to "exhaust air". Air pressure in the first air channel 111 is "positive pressure" relative to atmospheric pressure. A fan of the second fan module 82 is configured to "blow air". Air pressure in the second air channel 112 is "negative pressure" relative to the atmospheric pressure.

The embodiments of the present application are described in detail above. The principles and implementations of the present application are described by using specific examples in the specification. The descriptions of the foregoing embodiments are merely used to help understand the method and core ideas of the present application. In addition, for those skilled in the art, changes may be made in the implementations and the application scopes based on the ideas of the present application. In conclusion, the content of the specification should not be understood as a limitation on the present application.

## Claims

1. An electronic device comprising a chassis body, a first partition plate, a middle layer plate, a board, and a first cushioning member; the chassis body is provided with an accommodation space, and the first partition plate, the middle layer plate, the board, and the first cushioning member are all located in the accommodation space;
the board is fixedly connected to the chassis body, the board extends along a height direction of the electronic device, and the board comprises a first surface and a second surface that are disposed facing away from each other;
the first partition plate is fixedly connected to the chassis body, the first partition plate is further connected to the first surface of the board, and the first partition plate extends along a length direction of the electronic device;
the first cushioning member is connected to the second surface of the board, and the first cushioning member extends along a width direction of the electronic device;
the middle layer plate is fixedly connected to the chassis body, the middle layer plate is further connected to the first cushioning member, and the middle layer plate extends along the length direction of the electronic device; and
the accommodation space comprises a first air channel and a second air channel, the second air channel and the first air channel are sequentially disposed in a height direction of the electronic device, and the first air channel and the second air channel are isolated by the first partition plate, the board, the first cushioning member, and the middle layer plate.

2. The electronic device according to claim 1, wherein the middle layer plate comprises a base plate and a connecting member, the base plate comprises a first side edge facing the board, the first side edge is spaced apart from the first cushioning member, and in the width direction of the electronic device, a length of the connecting member is greater than or equal to a length of the first side edge, the connecting member comprises a first connecting part and a second connecting part, the first connecting part is fixedly connected to the first side edge, and the second connecting part protrudes from the first side edge; and the second connecting part is connected to the first cushioning member.

3. The electronic device according to claim 2, wherein the second connecting part comprises a first section, a bent section, and a second section, the second section and the first section are stacked, and the bent section is bent and connected between the first section and the second section; the bent section is in contact with the first cushioning member, and a thickness of the second connecting part is greater than a thickness of the first connecting part.

4. The electronic device according to claim 2 or 3, wherein the second surface of the board comprises a first area and a second area that are adjacently disposed, the electronic device further comprises a first insulator, and the first insulator is connected to the second area; and a first mounting slot is recessed in a surface of the first insulator away from the board, and at least a part of the first cushioning member is located in the first mounting slot.

5. The electronic device according to any one of claims 1 to 4, wherein the electronic device further comprises a second cushioning member, the second cushioning member is connected to the first surface of the board, and a surface of the second cushioning member facing away from the board is connected to the first partition plate.

6. The electronic device according to claim 5, wherein the first partition plate comprises a first partition plate body and a first folded edge, the first folded edge is connected to an end of the first partition plate body facing the board, and the first folded edge is arranged at an included angle with the first partition plate body; and the first folded edge is connected to the second cushioning member.

7. The electronic device according to any one of claims 1 to 6, wherein the electronic device further comprises a first rear frame body, and the first rear frame body is detachably connected to the chassis body;
the first rear frame body comprises an upper layer plate, the middle layer plate, a lower layer plate, a first side plate, and a second side plate, wherein along the height direction of the electronic device, the lower layer plate, the middle layer plate, and the upper layer plate are arranged sequentially and spaced apart from each other; and along the width direction of the electronic device, the first side plate and the second side plate are respectively connected to opposite sides of the lower layer plate, the middle layer plate, and the upper layer plate;
the upper layer plate, the middle layer plate, the board, the first side plate, and the second side plate cooperate to enclose a fan zone, the fan zone is located in the first air channel, and the fan zone is configured to accommodate a fan module or a functional module; and
the middle layer plate, the board, the lower layer plate, the first side plate, and the second side plate cooperate to enclose a pluggable module zone, the pluggable module zone is located in the second air channel, and the pluggable module zone is configured to accommodate a fan module or a functional module.

8. The electronic device according to claim 7, wherein the first rear frame body further comprises a clamping plate and a plurality of first baffles, and two ends of the clamping plate are respectively connected to the first side plate and the second side plate, and along the height direction of the electronic device, the clamping plate is located between the upper layer plate and the lower layer plate and is spaced apart from the upper layer plate and the lower layer plate, and the plurality of first baffles are spaced apart in a gap area between the upper layer plate and the clamping plate and a gap area between the clamping plate and the middle layer plate; and a gap area between two adjacent first baffles is configured to accommodate a fan.

9. The electronic device according to claim 8, wherein the electronic device further comprises a first fan board and a second fan board;
the first fan board is fixedly connected to the clamping plate, the first fan board is spaced apart from each of the plurality of first baffles connected between the upper layer plate and the clamping plate, and the first fan board is configured to be electrically connected to a plurality of fans located between the upper layer plate and the clamping plate; and
the second fan board is fixedly connected to the middle layer plate, one end of the second fan board extending from the middle layer plate is connected to the board through the first insulator, and the second fan board is spaced apart from each of the plurality of first baffles connected between the clamping plate and the middle layer plate, the second fan board is configured to be electrically connected to a plurality of fans located between the clamping plate and the middle layer plate, and the second fan board is electrically connected to the first fan board and the board.

10. The electronic device according to any one of claims 7 to 9, wherein the electronic device further comprises a second insulator, a third cushioning member, and a first top plate;
the first top plate is fixedly connected to the chassis body, and along the height direction of the electronic device, and the first top plate is stacked with the lower layer plate of the first rear frame body;
the second insulator is connected to the second area, the second insulator and the first insulator are opposite each other and spaced apart, and a second mounting slot is recessed in a surface of the second insulator away from the board; and
at least a part of the third cushioning member is located in the second mounting slot, and a surface of the third cushioning member away from the second insulator is configured to be connected to the first top plate.

11. The electronic device according to claim 10, wherein the first top plate comprises a first top plate body and an extension edge, one end of the extension edge is fixedly connected to the first top plate body, and the other end of the extension edge is connected to the third cushioning member; and the extension edge is arranged at an included angle with the first top plate body.

12. The electronic device according to claim 10, wherein the accommodation space further comprises a third air channel, wherein the third air channel, the second air channel, and the first air channel are sequentially disposed in the height direction of the electronic device, and the electronic device further comprises a second partition plate; and the second partition plate is fixedly connected to the chassis body and spaced apart from the first partition plate, the second partition plate is further connected to the first surface of the board, and the second partition plate extends along the length direction of the electronic device; and the third air channel and the second air channel are isolated by the second partition plate, the board, the third cushioning member, and the first top plate.

13. The electronic device according to any one of claims 7 to 12, wherein the chassis body, the first partition plate, and the board cooperate to enclose a first functional zone, the first functional zone is located in the first air channel, and the first functional zone is in communication with the fan zone; and the first functional zone is configured to accommodate a functional module;
the chassis body, the first partition plate, the second partition plate, and the board cooperate to enclose a second functional zone, the second functional zone is located in the second air channel, the second functional zone is connected to the pluggable module zone, and the second functional zone is configured to accommodate a functional module; and
the electronic device further comprises a first fan module and a second fan module, wherein the first fan module is disposed in the first air channel, and the second fan module is disposed in the second air channel, wherein:
the first fan module and the second fan module are located on a same side of the board, wherein the first fan module is located in the first functional zone, and the second fan module is located in the second functional zone; or
the first fan module and the second fan module are located on a same side of the board, wherein the first fan module is located in the fan zone, and the second fan module is located in the pluggable module zone; or
the first fan module and the second fan module are located on different sides of the board, wherein the first fan module is located in the fan zone, and the second fan module is located in the second functional zone; or
the first fan module and the second fan module are located on different sides of the board, wherein the first fan module is located in the first functional zone, and the first fan module is located in the pluggable module zone.

14. The electronic device according to any one of claims 1 to 13, wherein the electronic device is a server.
